(19)
Europäisches Patentamt
European Patent Office
Office européen des brevets

(11) **EP 1 918 731 B1**

(12) **EUROPÄISCHE PATENTSCHRIFT**

(45) Veröffentlichungstag und Bekanntmachung des Hinweises auf die Patenterteilung:
**07.03.2012 Patentblatt 2012/10**

(51) Int Cl.:
***G01R 33/30*** *(2006.01)*

(21) Anmeldenummer: **07021385.5**

(22) Anmeldetag: **02.11.2007**

(54) **Probenbehälter für NMR-Messungen mit Feldhomogenisierung im Probenvolumen durch die Grenzflächen des Probenbehälters**

Sample container for NMR measurements with homogenisation of sample volume by sample container boundaries

Conteneur d'échantillons pour mesures RMN avec homogénéisation de champ dans le volume d'échantillon par les surfaces de contact du conteneur d'échantillons

(84) Benannte Vertragsstaaten:
**CH DE FR GB LI**

(30) Priorität: **04.11.2006 DE 102006052076**

(43) Veröffentlichungstag der Anmeldung:
**07.05.2008 Patentblatt 2008/19**

(73) Patentinhaber: **Bruker BioSpin AG**
**8117 Fällanden (CH)**

(72) Erfinder:
- **Fey, Michael**
  **5075 Hornussen (CH)**
- **Speck, Thomas**
  **8800 Thalwil (CH)**

(74) Vertreter: **Kohler Schmid Möbus**
**Patentanwälte**
**Ruppmannstraße 27**
**70565 Stuttgart (DE)**

(56) Entgegenhaltungen:
EP-A- 0 285 853    JP-A- 6 249 934
US-A- 4 549 136    US-A- 5 302 900
US-A- 5 831 434    US-A1- 2005 024 055

- **ANONYMOUS: "NMR SAMPLE TUBES" SAMPLE TUBE QUALITY/APPLICATION NOTE, [Online] 4. Oktober 2006 (2006-10-04), XP002470172 MR Resources Gefunden im Internet: URL:http://web.archive.org/web/20061004014 954/http://mrr.com/> [gefunden am 2008-02-22]**
- **LEROY J-L ET AL: "Solution structures of the i-motif tetramers of d(TCC), d(5methylCCT) and d(T5methylCC): novel NOE connections between amino protons and sugar protons" STRUCTURE, CURRENT BIOLOGY LTD., PHILADELPHIA, PA, US, Bd. 3, Nr. 1, Januar 1995 (1995-01), Seiten 101-120, XP004587818 ISSN: 0969-2126**
- **KUCHEL PW ET AL: "Magnetic susceptibility: Solutions, emulsions and cells" CONCEPTS IN MAGNETIC RESONANCE PART A, Bd. 18A, 2003, Seiten 56-71, XP002470173**
- **DURRANT CL ET AL: "Magnetic susceptibility: Further insights into macroscopic and microscopic fields and the sphere of Lorentz" CONCEPTS IN MAGNETIC RESONANCE PART A, Bd. 18A, 2003, Seiten 72-95, XP002470174**
- **OSBORN JA: "Demagnetizing factor of the general ellipsoid" PHYSICAL REVIEW, Bd. 67, 1. Juni 1945 (1945-06-01), Seiten 351-357, XP002470175**

**Beschreibung**

Die Erfindung betrifft eine Messanordnung für NMR-Messungen, umfassend einen Probenbehälter, eine Umgebung mit einer magnetischen Suszeptibilität $X_1$, und eine flüssige Probe mit einer magnetischen Suszeptibilität $X_3$, wobei der Probenbehälter aus einem Behältermaterial der magnetischen Suszeptibilität $X_2$ besteht,
mit einer äußeren Grenzfläche, die den Probenbehälter zur Umgebung hin begrenzt,
und mit einer inneren Grenzfläche, die den Probenbehälter zu einem Probenvolumen begrenzt,
wobei die äußere Grenzfläche umfasst

- eine äußere Zylinderfläche, die zylindermantelförmig ausgebildet ist und mit ihrer Längsachse parallel zu einer z-Richtung ausgerichtet ist,
- und eine äußere Abschlussfläche, die den Probenbehälter am unteren Ende abschließt und sich an die äußere Zylinderfläche anschließt,

und wobei die innere Grenzfläche umfasst

- eine innere Zylinderfläche, die zylindermantelförmig ausgebildet ist und mit ihrer Längsachse parallel zur z-Richtung ausgerichtet ist,
- und eine innere Abschlussfläche, die das Probenvolumen am unteren Ende abschließt und sich an die innere Zylinderfläche anschließt,

wobei der Probenbehälter in der Umgebung angeordnet ist und die flüssige Probe im Probenvolumen des Probenbehälters angeordnet ist.

Ein solcher Probenbehälter ist bekannt geworden durch SCHOTT Duran Laborglaskatalog 2005/2006, S. 62.

NMR-Spektroskopie ist ein Verfahren der instrumentellen Analytik, bei dem eine Messprobe einem starken statischen Magnetfeld ausgesetzt wird. Die Messprobe wird dann elektromagnetischen Pulsen ausgesetzt, und die Reaktion der Atomkerne in der Messprobe wird gemessen und analysiert.

Eine Voraussetzung für qualitativ hochwertige Messergebnisse ist eine gute Homogenität des statischen Magnetfelds in der Messprobe. Die Messproben (in der Regel eine Substanz gelöst in einem Lösungsmittel wie Aceton oder Wasser, also eine flüssige Probe) ist in einem Probenbehälter angeordnet. Der Probenbehälter verzerrt dabei im Allgemeinen das im Außenbereich homogene, statische Magnetfeld in seinem Inneren, so dass es zu Qualitätseinbußen im Messergebnis kommen kann.

Bei Standard-Probenbehältern wie aus dem SCHOTT Duran Glaskatalog bekannt weist der Probenbehälter einen zylindermantelförmigen Abschnitt und einen schalenförmigen Abschluss-Abschnitt auf; die Wandstärke ist im Wesentlichen überall gleich. Während der zylindermantelförmige Abschnitt nur kleine Verzerrungen erzeugt, kann durch den Abschluss-Abschnitt eine starke Feldverzerrung auftreten. Eine Magnetfeldverzerrung wird hier vermieden, indem nur ein kleiner, vom Abschluss-Abschnitt ausreichend weit entfernter Teil des Probenvolumens (Probenvolumen = mit Messprobe ausgefüllter Bereich des Probenbehälters) als Messbereich genutzt wird. Dadurch wird auch nur ein kleiner Teil der zur Verfügung stehenden Probenmasse vermessen, was das Signal-zu-Rausch-Verhältnis verschlechtert. Dies ist insbesondere von Bedeutung, wenn nur wenig Probensubstanz zur Verfügung steht und diese zur Befüllung des gesamten Probenvolumens entsprechend verdünnt werden muss.

Weiterhin sind auch Probenbehälter bekannt geworden, bei denen der Raum zwischen unterem Ende des Probenbehälters und dem Messbereich massiv ausgeführt ist, so dass dieser Raum nicht durch Messsubstanz gefüllt werden muss. Allerdings kann es dann durch die innere Grenzfläche zwischen dem Probenbehälter und der Messprobe (die in aller Regel eine flüssige Probe ist) zu Magnetfeldverzerrungen im Probenvolumen kommen. Aus [2] ist bekannt, die magnetische Suszeptibilität des Materials des Probenbehälters entsprechend der magnetischen Suszeptibilität der flüssigen Probe zu wählen, um Verzerrungen zu verringern [2]. Die Einstellung der Suszeptibilität des Materials des Probenbehälters ist jedoch schwierig und teuer. Ebenfalls bekannt ist es, die innere Grenzfläche des Probenbehälters mit rotationsellipsoider Form auszugestalten, etwa kugelförmig [4] oder mit Hilfe von Verdrängungskörpern [5], wodurch ebenfalls Verzerrungen vermindert werden.

Bei all diesen Probenbehältern muss jedoch nach wie vor das untere Ende des Probenbehälters weit vom Messbereich, etwa dem Inneren eines HF-Resonatorsystems, entfernt sein, um Verzerrungen des statischen Magnetfelds im Messbereich zu vermeiden. Infolgedessen ist es erforderlich, im Messkopf genügend Raum unterhalb des Messbereichs für das untere Ende Probenbehälters zu belassen.

Aufgabe der Erfindung

Es ist demgegenüber die Aufgabe der vorliegenden Erfindung, einen Probenbehälter vorzustellen, in dessen Probenvolumen im Wesentlichen überall eine hohe Homogenität des statischen Magnetfelds erreicht werden kann, und der einen kompakteren Bau des Messkopfs ermöglicht.

Kurze Beschreibung der Erfindung

Diese Aufgabe wird gelöst durch einen Probenbehälter der eingangs genannten Art, dadurch gekennzeichnet, dass die äußere Grenzfläche, einschließlich der form der äußeren Abschlußfläche, und die innere Grenzfläche, einschließlich der form der inneren Abschlußfläche, so ausgebildet sind, dass bei Anlegen eines äußeren, homogenen Magnetfelds $B_0$ parallel zur z-Achse gilt:

- die äußere Grenzfläche bewirkt durch den Suzeptibilitätssprung von $\chi_1$ auf $\chi_2$ im Bereich des Probenvolumens ein Feld $B_z^{(1)}$ mit einem Mittelwert im Probenvolumen $< B_z^{(1)} >$ und damit eine erste relative Feldänderung F1 = $(B_z^{(1)}- < B_z^{(1)} >) / B_0$, die zumindest in einem Teil des Probenvolumens betragsmäßig wenigstens $0.5 \cdot 10^{-6}$ beträgt;
- die innere Grenzfläche bewirkt durch den Suzeptibilitätssprung von $\chi_2$ auf $\chi_3$ im Bereich des Probenvolumens ein Feld $B_z^{(2)}$ mit einem Mittelwert im Probenvolumen $< B_z^{(2)} >$ und damit eine zweite relative Feldänderung F2 = $(B_z^{(2)}- < B_z^{(2)} >) / B_0$, die zumindest in einem Teil des Probenvolumens betragsmäßig wenigstens $0.5 \cdot 10^{-6}$ beträgt,
- die erste relative Feldänderung F1 und die zweite relative Feldänderung F2 heben sich im Probenvolumen V im Wesentlichen auf, so dass gilt

$$\sqrt{\int_V (F1 + F2)^2 \, dV} \leq 0.9 \cdot \sqrt{\int_V (F3)^2 \, dV}$$

wobei die innere Grenzfläch, wenn are die durch die innere Grenzfläche begrenzte Flüssige Probe allein und der Probenbehälter nicht vorhanden wäre, durch einen Suszeptibilitätssprung von $\chi_1$ auf $\chi_3$ im Bereich des Probenvolumens ein Feld $B_z^{(3)}$ mit einem Mittelwert im Probenvolumen $< B_z^{(3)} >$ und damit eine dritte relative Feldänderung F3 = $(B_z^{(3)}- < B_z^{(3)} >) / B_0$ bewirken würde.

Kern der vorliegenden Erfindung ist es, die äußere Grenzfläche und die innere Grenzfläche in ihrer Geometrie so aufeinander abzustimmen, dass die durch sie im Probenvolumen jeweils auftretenden relativen Magnetfeldänderungen sich im Wesentlichen aufheben. Als Maßstab wird dabei eine fiktive Feldveränderung F3 im Probenvolumen durch die flüssige Probe allein herangezogen (zusätzlich kann aber auch ein Vergleich mit einem Festwert von maximaler relativer Feldänderung herangezogen werden, etwa $|F1 + F2| \leq 0,5 \cdot 10^{-6}$ überall im Probenvolumen). Für die erfindungsgemäße Abstimmung von äußerer und innerer Grenzfläche ist regelmäßig eine geeignete Formgebung von äußerer und innerer Abschlussfläche ausreichend.

Dabei können und müssen die äußere und die innere Abschlussfläche im Rahmen der Erfindung eng zusammen bleiben (typischerweise sodass der maximale Abstand parallel zur z-Richtung kleiner oder gleich dem Durchmesser des der äußeren Zylinderfläche des Probenbehälters beträgt); eine zu weit vom Probenvolumen entfernte äußere Abschlussfläche könnte keine ausreichende Kompensationswirkung entfalten. Der Probenbehälter ragt erfindungsgemäß allenfalls unwesentlich unterhalb des Messbereichs heraus. Der untere (abschlussflächennahe) Teil des Probenvolumens kann in einer NMR-Messung mitgenutzt werden, denn dort wird mit Hilfe der Erfindung eine gute Homogenität des Magnetfelds sichergestellt.

Im Rahmen der Erfindung wird die Geometrie des Probenbehälters, insbesondere die Form von äußerer und innerer Abschlussfläche, auf die Suszeptibilitäten von Umgebung $\chi_1$ (etwa Luft oder Stickstoff), Material des Probenbehälters $\chi_2$ (etwa verschiedene Glastypen) und flüssiger Probe $\chi_3$ (etwa verschiedene Lösungsmittel wie Wasser oder Aceton) abgestimmt. Im Rahmen der Erfindung kann ein Set von Probenbehältern erstellt werden, wobei ein jeder Probenbehälter auf eine andere Kombination von Umgebung und flüssiger Probe abgestimmt ist. Ein Probenbehälter wird genau für die Kombination von Umgebung und flüssiger Probe verwendet, auf die er abgestimmt ist. Die Suszeptibilität des Materials des Probenbehälters ist innerhalb der gegebenen Nebenbedingungen beliebig, wird aber innerhalb eines Sets typischerweise nicht verändert.

Mit dem erfindungsgemäßen Probenbehälter können deutlich bessere NMR-Resultate bei reduziertem Probenvolumen erreicht werden. Gleichzeitig kann eine kompaktere Bauweise des Messkopfs bzw. eine Verkürzung des Probenbehälters erreicht werden.

Bevorzugte Ausführungsformen der Erfindung

Besonders bevorzugt ist eine Ausführungsform des erfindungsgemäßen Probenbehälters, die vorsieht, dass

gilt $\sqrt{\int\limits_{V}(F1+F2)^2\,dV} \le 0.5 \cdot \sqrt{\int\limits_{V}(F3)^2\,dV}$,

und insbesondere dass gilt $\sqrt{\int\limits_{V}(F1+F2)^2\,dV} \le 0.1 \cdot \sqrt{\int\limits_{V}(F3)^2\,dV}$. In diesem Fall ist

die Kompensationswirkung verstärkt, so dass die Qualität der NMR-Messungen noch weiter verbessert ist.

Eine weitere bevorzugte Ausführungsform sieht vor, dass überall im Probenvolumen gilt $|F1 + F2| \le 0.5 \cdot 10^{-6}$, und insbesondere dass gilt $|F1 + F2| \le 0.1 \cdot 10^{-6}$. Damit wird ebenfalls eine verstärkte Kompensationswirkung sichergestellt, die die Qualität der NMR-Messungen weiter verbessert.

Besonders bevorzugt ist eine Ausführungsform, bei der gilt:

$\chi_2\chi_3 > 0$ und $|\chi_2| > |\chi_3|$, insbesondere wobei $|\chi_2|/|\chi_3| > 1.1$. Diese Relationen können leicht durch geeignete Wahl des Materials des Probenbehälters erreicht werden. Bei Einhaltung dieser Relationen ist eine ausreichende und gegenläufige Feldänderung durch die innere und äußere Grenzfläche leicht einstellbar.

Bei einer bevorzugten Ausführungsform ist der Probenbehälter aus Borosilikatglas oder Quarzglas gefertigt. Diese Materialien sind in der Praxis bewährt und weisen außerdem für die Erfindung gut brauchbare magnetische Suszeptibilitäten auf.

Ganz besonders bevorzugt ist eine Ausführungsform, bei der der Probenbehälter bezüglich $\chi_1$ für eine Umgebung von Luft, Stickstoffgas oder einem Edelgas, insbesondere Argon, ausgelegt ist. Diese Umgebungen kommen in der Laborpraxis häufig vor.

Ebenso ganz besonders bevorzugt ist eine Ausführungsform, bei der der Probenbehälter bezüglich $\chi_3$ für ein Lösungsmittel der flüssigen Probe von Wasser oder Aceton ausgelegt ist. Das Lösungsmittel dominiert in der Regel die magnetische Suszeptibilität einer flüssigen Probe. Wasser und Aceton sind ebenfalls in der Laborpraxis häufig verwendet.

Bei einer bevorzugten Ausführungsform ist der Probenbehälter bezüglich der z-Richtung rotationssymmetrisch ausgebildet. Dies erlaubt die Reduktion der winkelabhängigen Feldinhomogenitäten durch Rotation des Samples.

Ganz besonders bevorzugt ist eine Ausführungsform eines erfindungemäßen Probenbehälters, die vorsieht, dass die äußere Abschlussfläche und die innere Abschlussfläche jeweils als Halbellipsoide ausgebildet sind, wobei ein Halbellipsoid dadurch definiert ist, dass ein Rotationsellipsoid senkrecht zu seiner Rotationsachse halbiert ist, dass die äußere Grenzfläche und die innerer Grenzfläche jeweils bei gleicher Position in z-Richtung von der Abschlussfläche in die Zylinderfläche übergehen, und dass näherungsweise gilt:

$$(\chi_2 - \chi_1)(1 - g(\alpha_1)) = -(\chi_3 - \chi_2)(1 - g(\alpha_2)),$$

wobei

$\alpha_1 =$ Formwinkel des Halbellipsoides der äußeren Abschlussfläche,

$\alpha_2 =$ Formwinkel des Halbellipsoides der inneren Abschlussfläche,

$$g(\alpha_1) = 1 - \frac{\tan(\alpha_1) \cdot \ln\left(\tan(\alpha_1) + \sqrt{\tan(\alpha_1)^2 - 1}\right)}{\left(\tan(\alpha_1)^2 - 1\right)^{3/2}} + \frac{1}{\tan(\alpha_1)^2 - 1},$$

$$g(\alpha_2) = 1 - \frac{\tan(\alpha_2) \cdot \ln\left(\tan(\alpha_2) + \sqrt{\tan(\alpha_2)^2 - 1}\right)}{\left(\tan(\alpha_2)^2 - 1\right)^{3/2}} + \frac{1}{\tan(\alpha_2)^2 - 1}.$$

Die Probenbehälter dieser Ausführungsform erreichen eine gute Magnetfeldhomogenität im gesamten Probenvolumen und benötigen keinen merklichen Überstand unterhalb des Messbereichs.

Bei einer bevorzugten Weiterbildung dieser Ausführungsform gilt

$$(\chi_2 - \chi_1)(1 - g(\alpha_1)) = -(\chi_3 - \chi_2)(1 - g(\alpha_2)) \cdot U,$$

mit $0,95 \leq U \leq 1,05$, insbesondere $0,99 \leq U \leq 1,01$. Diese Näherungen sind in der Praxis ausreichend für eine gute Homogenität im Probenvolumen.

Besonders bevorzugt ist auch eine Ausführungsform, bei der die innere Abschlussfläche und die äußere Abschlussfläche in z-Richtung einen maximalen Abstand von 3 mm aufweisen. Bei diesem maximalen Abstand kann mit der äußeren Abschlussfläche noch eine gute Kompensationswirkung im Probenvolumen erzielt werden. Man beachte, dass das Messvolumen im Rahmen der Erfindung sich typischerweise bis zur inneren Abschlussfläche erstreckt, und daher ein Überstand des Probenbehälters unterhalb des Messvolumens nur sehr gering ist (bei dieser Ausführungsform maximal 3 mm).

In den Rahmen der vorliegenden Erfindung fällt auch ein Verfahren zur Bestimmung der Gestalt der äußeren und inneren Grenzfläche gemäß Anspruch 12.

Mit diesem Verfahren können erfindungsgemäße Probenbehältergeometrien ohne weiteres gefunden werden.

Weitere Vorteile der Erfindung ergeben sich aus der Beschreibung und den Zeichnungen. Die gezeigten und beschriebenen Ausführungsformen sind nicht als abschließende Aufzählung zu verstehen, sondern haben vielmehr beispielhaften Charakter für die Schilderung der Erfindung.

Zeichnung und detaillierte Beschreibung der Erfindung

Die Erfindung ist in der Zeichnung näher dargestellt und erläutert. Es zeigen:

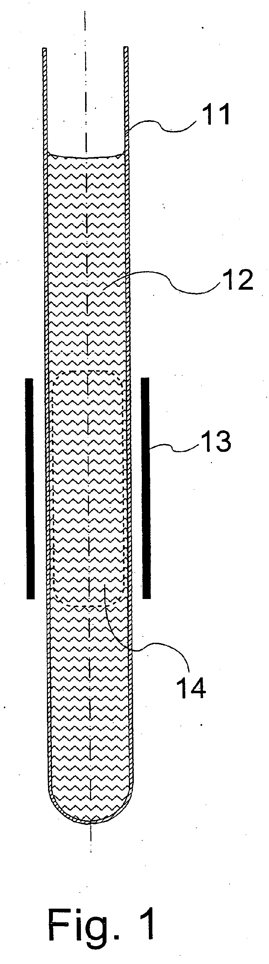

Fig. 1 einen schematischen Querschnitt durch einen NMR-Probenbehälter des Standes der Technik, mit konstanter Wandstärke;

Fig. 2a einen schematischen Querschnitt durch einen NMR-Probenbehälter des Standes der Technik nach [2];

Fig. 2b einen schematischen Querschnitt durch einen NMR-Probenbehälter des Standes der Technik nach [4];

Fig. 2c einen schematischen Querschnitt durch einen NMR-Probenbehälter des Standes der Technik nach [5];

Fig. 3 ein Diagramm zur Erläuterung des magnetischen Geometriefaktors g in Abhängigkeit vom Formwinkel $\alpha$;

Fig. 4a einen schematischen Längsschnitt durch einen Rotationskörper;

Fig. 4b ein Diagramm zur Erläuterung der relativen Feldänderung auf der Achse des Rotationskörpers von Fig. 4a;

Fig. 5a einen schematischen Querschnitt durch einen erfindungsgemäßen Probenbehälter mit flacher innerer Abschlussfläche;

Fig. 5b ein Diagramm zur Erläuterung der relativen Feldänderung, insbesondere F3, im Inneren des erfindungsgemäßen Probenbehälters von Fig. 5a;

Fig. 5c ein Diagramm zur Erläuterung der relativen Feldänderungen, insbesondere F1 und F2, im Inneren des erfindungsgemäßen Probenbehälters von Fig. 5a;

Fig. 6a einen schematischen Querschnitt durch einen weiteren erfindungsgemäßen Probenbehälter mit ellipsoider innerer Abschlussfläche;

Fig. 6b ein Diagramm zur Erläuterung der relativen Feldänderung, insbesondere F3, im Inneren des erfindungsgemäßen Probenbehälters von Fig. 6a;

Fig. 6c ein Diagramm zur Erläuterung der relativen Feldänderungen, insbesondere F1 und F2, im Inneren des erfindungsgemäßen Probenbehälters von Fig. 6a;

Fig. 7 ein allgemeiner Probenbehälter zur Erläuterung der Gebiete und Grenzflächen im Rahmen der Erfindung;

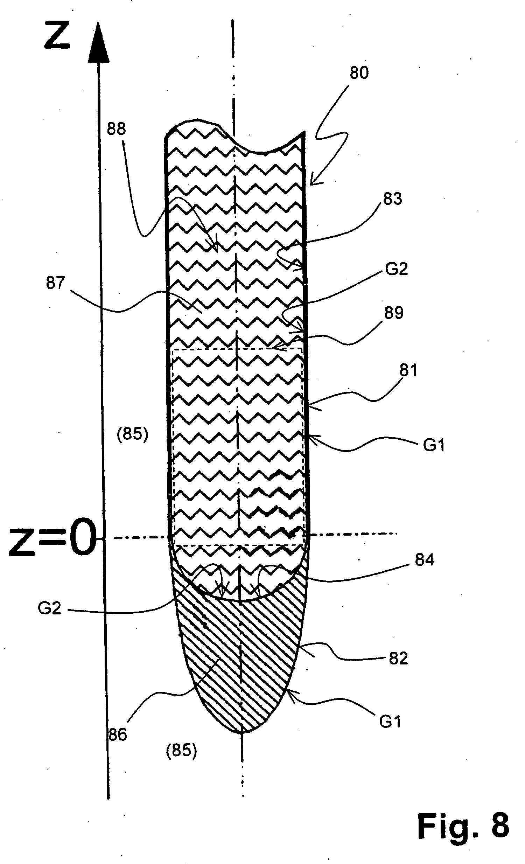

Fig. 8    ein erfindungsgemäßer Probenbehälter zur Erläuterung der Gebiete und Grenzflächen im Rahmen der Erfindung.

## 1. Überblick über die Erfindung

Ein Probenbehälter aus Material mit magnetischer Suszeptibilität $\chi_2$, zur Aufnahme einer Probensubstanz mit einer magnetische Suszeptibilität $\chi_3 \neq \chi_2$, welche in einem Kernspinresonanz- (NMR) Spektrometer untersucht werden soll, besitzt eine innere Grenzfläche $G_2$ zur Probensubstanz und eine äußere Grenzfläche $G_1$ zur Umgebung, welche eine magnetischer Suszeptibilität $\chi_1$ aufweist. Dabei sind die Formgebung der Grenzfläche zur Probensubstanz und der Grenzfläche zur Umgebung derart auf die Suszeptibilitätssprünge an den Grenzflächen abgestimmt, dass beim Einführen des mit Probensubstanz gefüllten Probenröhrchens in das zuvor homogene Magnetfeld eines NMR-Spektrometers das Magnetfeld innerhalb der Probensubstanz weitgehend homogen bleibt.

## 2. Hintergrund der Erfindung

### 2.1 Anwendungsgebiet

Die Erfindung bezieht sich auf einen Behälter zur Aufnahme einer Substanz, welche in einem NMR-Spektrometer analysiert wird.

### 2.2. Stand der Technik

### NMR-Spektroskopie

NMR-Spektroskopie ist ein vielseitiges Werkzeug bei der chemischen Analyse von Proben. Eine Probe wird in ein starkes, statisches Magnetfeld gebracht und elektromagnetischen Impulsen ausgesetzt. Die Reaktion der Atomkerne in der Probe wird gemessen und analysiert.

Die Eigenschaften des statischen Magnetfeldes beeinflussen die Qualität der Messergebnisse. Im Allgemeinen wird die beste Qualität mit großer Magnetfeldstärke und mit hoher Homogenität des statischen Magnetfeldes erreicht.

Die höchsten Feldstärken für das statische Magnetfeld erreicht man mit supraleitenden Spulensystemen. Für hochauflösende NMR-Spektroskopie werden Feldstärken bis 21 Tesla verwendet. Die typische Messanordnung, wie sie in modernen Spektrometern verwendet wird, besteht aus einer zylindrischen, supraleitenden Spule, welche in einem zylindrischen Innenraum ein starkes Magnetfeld parallel zur Achse erzeugt, und einer Anzahl von Shimspulen, Gradientenspulen und Radiofrequenzspulen, weiche in diesem Innenraum auf verschiedenen Radien um einen Probenbehälter herum angeordnet sind. Der Probenbehälter enthält die zu untersuchende Substanz. Das Material des Probenbehälters muss elektrisch isolierend (durchlässig für Radiofrequenzstrahlung) und chemisch inert sein.

### Form des Probenbehälters

Die Form des Probenbehälters kann je nach Anwendung die verschiedensten Formen haben. Typischerweise handelt es sich aber um lange, rotationssymmetrische Zylinder. Für die Wahl dieser Geometrie gibt es zwei Gründe. Erstens erzeugt ein zylindrischer Probenbehälter nur an den Enden magnetische Störungen, die durch genügend große Entfernung zum Messvolumen nur wenig Einfluss haben. Zweitens kann mit rotationssymmetrischen Probenbehältern während der Messung rotiert werden und damit können Feldinhomogenitäten, welche nicht rotationssymmetrisch sind, über die Zeit gemittelt werden und damit ihr Einfluss auf das Messresultat reduziert werden. Typischerweise beträgt in einer solchen Anordnung der Anteil des Probenvolumens, der zum gemessenen Signal beiträgt, nur etwa die Hälfte des gesamten Probenvolumens.

Diese zusätzliche Probenflüssigkeit hat die folgende Nachteile. Wenn nur wenig Probensubstanz zur Verfügung steht oder wenn die Probensubstanz sehr teuer ist, kann die Probensubstanz auf das notwendige Probenvolumen verdünnt werden um den Probenbehälter zu füllen. Damit verbunden ist aber eine unerwünschte Reduktion des Messsignals. In diesem Fall möchte man eigentlich die gesamte verfügbare Probensubstanz im Bereich hoher Messempfindlichkeit positionieren.

Des weiteren kann dieser Bereich ungewolltes NMR-Signal generieren wie etwa bei der Problematik der Lösungsmittelunterdrückung. Oft tritt die Situation auf, dass das NMR-Signal der Substanz, die untersucht werden soll (z.B. ein Protein), um einige Größenordnungen schwächer ist als das NMR-Signal des Lösungsmittels (z.B. Wasser), so dass es messtechnisch nicht möglich ist, das interessierende schwache Signal in Anwesenheit des unerwünschten starken Signals zu detektieren. Es gibt Verfahren, welche mittels geeigneter Pulssequenzen das Lösungsmittelsignal unterdrücken. Die ungewollten NMR-Signale aus diesem Bereich, der nur der Reduktion der magnetischen Störung des Probenbehälters dient, können in solchen Fällen größer als das eigentliche Nutzsignal werden.

Beide Probleme können reduziert werden, wenn die Störungen des Endes des Probenbehälters reduziert werden, das Ende näher an Messvolumen gebracht werden kann und sich dadurch im Randbereich der Radiofrequenzspule gar keine Probensubstanz mehr befindet.

Zwei Strategien sind bekannt, um die Probensubstanz auf den zentralen Bereich der Radiofrequenzspulen einzugrenzen und gleichzeitig die Entstehung von Inhomogenitäten im statischen Magnetfeld zu verhindern. Es sind dies:

- Das Anpassen der magnetischen Suszeptibilität
- Wahl der Grenzfläche zur Probensubstanz in Form eines Rotationsellipsoids.

Anpassen der magnetischen Suszeptibilität

Es entsteht keine Inhomogenität des Magnetfelds, wenn über die Grenzschicht zwischen Probensubstanz und dem angrenzenden Material hinweg die magnetische Suszeptibilität konstant bleibt. Im Patent von Zens [1] wird eine solche Anordnung beschrieben. Zwei zylindrische Verschlüsse schränken die Probensubstanz von oben und von unten auf den Bereich der Radiofrequenzspule ein. Die magnetische Suszeptibilität $\chi_1$ der Verschlüsse oder die magnetische Suszeptibilität des für die Probensubstanz verwendeten Lösungsmittels $\chi_2$ werden durch geeignete Wahl der verwendeten Substanzen so beeinflusst, dass beide Suszeptibilitäten denselben Wert haben. Die Grenzfläche zwischen den Verschlüssen und dem umgebenden Gas wird genügend weit weg positioniert, so dass die entstehende Feldinhomognität nur geringen Einfluss auf das Probenvolumen hat.

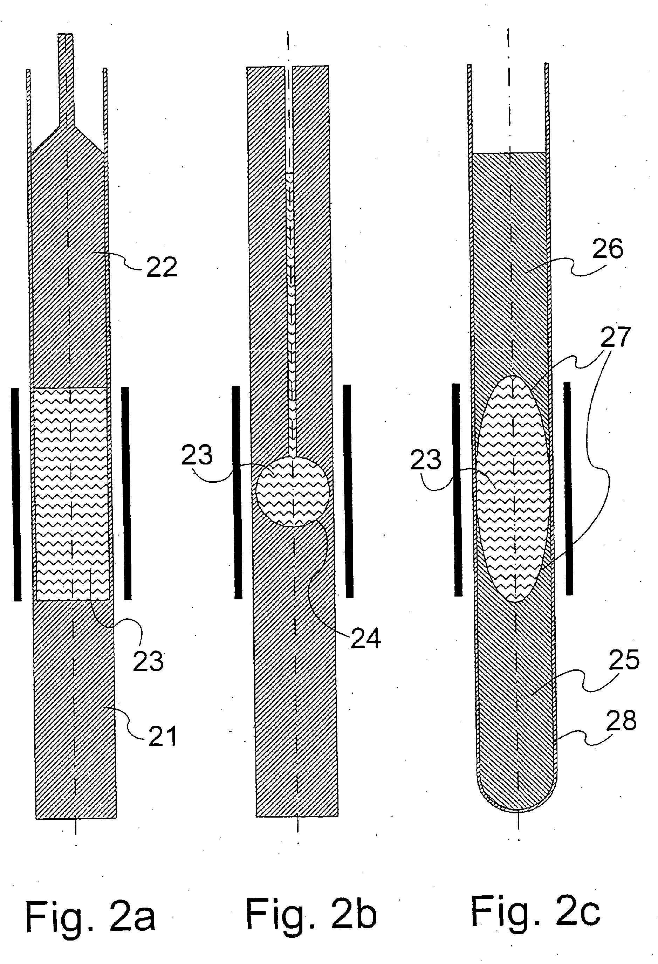

Im Patent von Shigezane [2] wird ein Probenbehälter aus Glas beschrieben, bei dessen Herstellung dem Glas eine genügend große Menge einer paramagnetischen Substanz beigemischt wurde, sodass die magnetische Suszeptibilität $\chi_2$ des Behältermaterials gerade der Suszeptibilität $\chi_3$ der zu untersuchenden Probensubstanz entspricht. Eine solche Anordnung ist in Figur 2a dargestellt. Auch hier sind die äußeren Grenzflächen weit vom Probenvolumen entfernt.

Grenzfläche in Form eines Rotationsellipsoids

Es ist bekannt [3], dass das Magnetfeld innerhalb eines Körpers, der die Grenzfläche eines Ellipsoids hat und aus magnetisch homogenem Material besteht, im Innern des Körpers homogen ist, falls von außen ein homogenes Magnetfeld angelegt wird. Die magnetische Suszeptibilität $\chi_1$ des Körpers darf sich in diesem Fall auch von der magnetischen Suszeptibilität $\chi_2$ der Probensubstanz unterscheiden - die Form der Grenzfläche allein sorgt dafür, dass das Magnetfeld homogen bleibt.

Im Patent von Fujita [4] wird ein kugelförmiger Hohlraum in einem langen, zylindrischen Probenbehälter freigelassen. In diesen Hohlraum kann durch eine Kapillare Probensubstanz eingefüllt werden. Ein solcher Probenbehälter wird in Figur 2b dargestellt. Die Kugelform ist ein Spezialfall eines Ellipsoids. Cummings [5] löst das Problem der limitierten Probensubstanz durch Einsetzen eines oberen und unteren Verdrängungskörpers in ein konventionelles Probenröhrchen. In einer vorteilhaften Variante dieser Idee wird die Grenzfläche der Verdrängungskörper zu der Probensubstanz gerade in Form eines halben Rotationsellipsoids gewählt. Ein konventioneller Probenbehälter, in den zwei solche Verdrängungskörper eingesetzt sind, wird in Figur 2c dargestellt. Auf diese Weise wird ein äußeres homogenes Magnetfeld im Innern der Probensubstanz nicht verzerrt und die Verdrängungskörper passen zu jeder Probensubstanz - unabhängig von deren magnetischer Suszeptibilität. Wie im Fall der Anpassung der magnetischen Suszeptibilität muss das der Probensubstanz ferne Ende der Verdrängungskörper genügend weit weg von der Probensubstanz sein, damit die an diesem Ende entstehende Feldinhomogenität keinen Einfluss auf das Probenvolumen hat.

Nachteile der bekannten Methoden

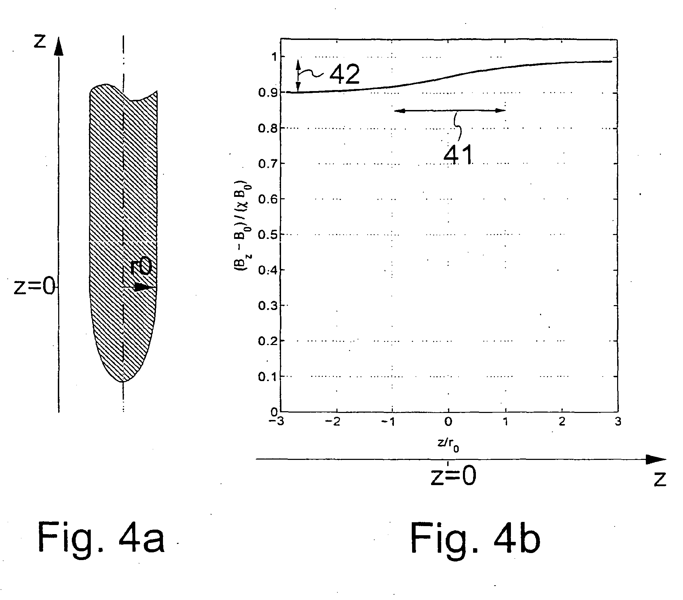

- Die entfernten Enden (Boden, Deckel) des Probenbehälters müssen bei beiden Methoden idealerweise weit entfernt sein, denn die Suszeptibilität $\chi_1$ der Umgebung ist im Allgemeinen deutlich verschieden von $\chi_2$ und $\chi_3$, was zu einer starken Inhomogenität in der Nähe von diesen Enden führt.
- Die Technologie der Herstellung von Gläsern mit Suszeptibilitätskorrekturen ist anspruchsvoll.
- Die verschiedenen in Probensubstanzen verwendeteten Lösungsmittel haben unterschiedliche Suszeptibilitäten. Somit muss für jedes zu verwendende Lösungsmittel ein anderes Rohmaterial bei der Herstellung des Probenbehälters eingesetzt werden.
- Die Geometrie der Innenfläche lässt sich nicht abschnittsweise durch Rotationsellipsoide definieren. So führt z. B. eine zylindrische Form mit gerundetem Abschluss bereits zu einer Inhomogenität des Magnetfeldes. Diese Situation ist in Figur 4.b illustriert.

## 3. Erfindungsgemäße Probenbehälter

Zum besseren Verständnis der erfinderischen Idee soll der Begriff "Grenzfläche" genauer definiert werden. Eine Grenzfläche soll die Fläche sein, die zwei Bereiche mit unterschiedlichen magnetischen Suszeptibilitäten $\chi$ voneinander trennt.

Ein NMR-Probenbehälter besitzt zwei Grenzflächen, eine innere und eine äußere. Die innere Grenzfläche befindet sich zwischen dem Probenbehälter mit der Suszeptibilität $\chi_2$ und der Probensubstanz (flüssige Probe) mit der Suszeptibilität $\chi_3$. Die äußere Grenzfläche befindet sich zwischen dem Probenbehälter und der Umgebung (z.B. Luft) mit der Suszeptibilität $\chi_1$.

Die erfinderische Idee besteht nun darin, die Form der beiden Grenzflächen so zu wählen, dass sich die Summe der entstehenden Inhomogenitäten der einzelnen Grenzfläche im Inneren der Probensubstanz weitestgehend aufhebt. Für die Lösung dieses Problems in allgemeinster Form, muss zunächst eine Lösung der Gleichungen der Magnetostatik gefunden werden [8].

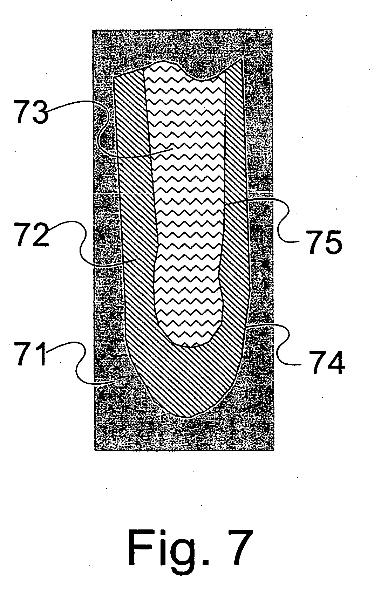

Zu gegebenen Geometrien, in diesem Fall gegeben durch zwei Grenzflachen $G_1$ (äußere Grenzfläche) und $G_2$ (innere Grenzfläche), die die drei Gebiete $\Omega_1$ (Umgebung), $\Omega_2$ (Probenbehälterwand) und $\Omega_3$ (flüssige Probe im Probenbehälter) mit den unterschiedlichen Suszeptibilitäten $\chi_1$, $\chi_2$ und $\chi_3$ separieren (siehe Figur 7), muss eine Lösung der Gleichungen

$$\nabla \cdot B_i = 0, \nabla \times B_i = 0, \nabla \cdot H_i = 0, \nabla \times H_i = 0$$

bestimmt werden. Dabei gilt $B_i = \mu_i H_i = \mu_0(1+\chi_i)H_i$ in jedem Gebiet $\Omega_i$. Folglich existieren Potentiale $\Psi_i$ mit $\nabla^2\Psi = 0$ und $H_i = -\nabla\Psi_i$. Außerdem müssen die Sprungbedingungen an den Grenzflächen erfüllt werden:

$$(\mu_2 H_2 - \mu_1 H_1) \cdot n = 0, \ \forall x \in G_1$$

$$(\mu_3 H_3 - \mu_2 H_2) \cdot n = 0, \ \forall x \in G_2$$

für die Normalkomponente der Felder und

$$(H_2 - H_1) \cdot t = 0, \ \forall x \in G_1$$

$$(H_3 - H_2) \cdot t = 0, \ \forall x \in G_2$$

für die tangentialen Komponenten. Die Randbedingungen sind durch das konstante Hintergrundfeld $H_0$ durch $\lim(-\nabla\Psi_3) = H_0 e_z$ für betragsmäßig große $x$ gegeben.

Eine numerische Lösung zu gegebenen Grenzflächen kann mittels kommerziell erhältlicher Software gelöst werden. Alternativ zu aufwendigen FEM-Verfahren, liefert für diese Aufgabenstellung ($|\chi| < 20$ ppm) auch die Näherung über die äquivalente Stromdichte gute Ergebnisse. In den Beispielen wird dieser Zugang noch etwas genauer erläutert, da alle Beispiele mit dieser Methode berechnet wurden. Mittels geeigneter Zielfunktionen und Suchalgorithmus können die beiden Grenzflächen so abgestimmt werden, dass die Störung im Inneren des Messvolumens minimiert wird.

Hier zeigt sich der Vorteil der erfinderischen Idee gegenüber dem Stand der Technik. In den oben erwähnten Fällen wird der Einfluss einer der Grenzflächen nur dadurch reduziert, dass diese Fläche weit entfernt vom Messvolumen platziert wird. Durch die Berücksichtigung beider Flächen können je nach Anwendung kompaktere Geometrien gewählt werden, die entweder Glasmaterial oder Probenflüssigkeit, in jedem Fall aber Platz sparen.

Typischerweise ist ein Probenbehälter aus einem zylindrischen Teil und einem Abschluss aufgebaut. Als zylinderförmige Fläche (= "Zylinderfläche") soll eine Fläche verstanden werden, die durch die Oberfläche eines allgemeinen Zylinders definiert ist. Ein allgemeiner Zylinder umfasst nicht nur den bekannten Kreiszylinder mit einer kreisrunden Querschnittsfläche, sondern auch alle anderen möglichen Formen der Querschnittsfläche. Eine zylinderförmige Fläche kann somit als eine in Richtung der Längsachse des Zylinders translationsinvariante (= z-invariante) Fläche definiert werden.

Der Stand der Technik kennt Abschlussflächen, die annähernd Halbkugeln sind, und wo die Wandstärke des Probenbehälters im Bereich dieser Halbkugeln ungefähr konstant ist. Auch flache Abschlüsse, die durch Glasstücke erzeugt werden sind möglich. Eine Reduktion der entsprechenden Feldinhomogenität wird durch einen genügend großen Abstand (etwa das Doppelte des Durchmessers) der Abschlussflächen vom aktiven Bereich erzeugt.

3.1 Bewertung der Kompensationswirkung

Hintergrund der erfinderischen Idee ist die gegenseitige Kompensation der Störungen generiert durch die innere und äußere Grenzfläche. Beide Einflüsse sollen eine gewisse Größe haben, sich im Endergebnis aber möglichst aufheben. Der Stand der Technik wählt hingegen den Weg, dass die Einflüsse beider Grenzflächen klein sind: Der Einfluss der inneren Grenzfläche wird durch die Wahl eines geeigneten Material, bzw. einer geeigneten Form klein, der Einfluss der äußeren durch einen genügend großen Abstand zum Messvolumen.

Trennung der Einflüsse der Grenzflächen

Aus den gegebenen Gleichungen lässt sich - rein rechnerisch - der Einfluss jeder einzelnen Grenzfläche auf das Probenvolumen bestimmen. Die Standardabweichung innerhalb des Probenvolumens der so berechneten Magnetfelder ist ein Maß für die Inhomogenität des Magnetfeldes. Diese Standardabweichung kann für das von der inneren Grenzfläche bewirkte Magnetfeld, für das von der äußeren Grenzfläche bewirkte Magnetfeld, sowie für das in der Kombination bewirkte Magnetfeld berechnet werden. Der erfindungsgemäße Probenbehälter ist nun dadurch gekennzeichnet, dass die Kombination der beiden Einflüsse zu einer wesentlichen Reduktion der Inhomogenität des Magnetfeldes führt, wenn man die aus der Kombination resultierende Inhomogenität mit der Inhomogenität des Magnetfeldes vergleicht, welche durch die Probensubstanz alleine verursacht würde (Sprung von $\chi_1$ auf $\chi_3$). Dies entspricht einem typischen Probenbehälter gemäss Stand der Technik mit einer konstant kleinen Wandstärke.

Wir führen daher die folgenden Größen ein:

$B_z^{(1)}$ : z-Komponente des Feldes, das die äußere Grenzfläche $G_1$ bewirkt, für einen Suszeptibilitätssprung von $\chi_1$ auf $\chi_2$

$B_z^{(2)}$ : z-Komponente des Feldes, das die innere Grenzfläche $G_2$ bewirkt, für einen Suszeptibilitätssprung von $\chi_2$ auf $\chi_3$

$B_z^{(3)}$ : z-Komponente des Feldes, das die innere Grenzfläche $G_2$ bewirkt, für einen Suszeptibilitätssprung von $\chi_1$ auf $\chi_3$

Die Inhomogenität des Feld wird durch die Abweichung vom Mittelwert beschrieben, wobei hier der Mittelwert im Probenvolumen von Interesse ist:

$$\langle B_z^{(1)}\rangle = \frac{1}{V}\int_V B_z^{(1)}\,dV \ , \ \langle B_z^{(2)}\rangle = \frac{1}{V}\int_V B_z^{(2)}\,dV \ \text{ und } \ \langle B_z^{(3)}\rangle = \frac{1}{V}\int_V B_z^{(3)}\,dV$$

Die Feldstärke $B_0$ des externen Magnetfeldes geht als Faktor in die obigen Größen ein. Man erhält die für die Geometrie und Suszeptibilitäten charakteristischen, relativen Feldänderungen F1, F2 und F3 durch Normierung auf $B_0$ :

$$F1 = (B_z^{(1)} - \langle B_z^{(1)}\rangle) / B_0$$

$$F2 = (B_z^{(2)} - \langle B_z^{(2)}\rangle) / B_0$$

$$F3 = (B_z^{(3)} - \langle B_z^{(3)}\rangle) / B_0$$

Von einer Kompensation der Inhomogenitäten kann dann gesprochen werden, wenn F1 und F2 alleine eine signifikante Inhomogenität beschreiben, ihre kombinierte Wirkung F1+F2 aber eine deutlich verringerte Inhomogenität aufweist, geringer als die Störung F3 des Probenvolumens alleine.

Eine für hochauflösende NMR signifikante Inhomogenität kann durch das Argument von Shigezane festgelegt werden: In [2] (Spalte 1, Zeile 39-42) wird für die beiden Suszeptibilitäten an einer stumpfen Grenzfläche gefordert dass ihre Differenz weniger als 10% der Probensuszeptibilität ausmachen darf, damit die resultierende Feldinhomogenität mit Hilfe von Shimspulen kompensiert werden kann. Bei der Samplegeometrie aus [2] beträgt die relative Feldänderung F2 an der Grenzfläche (dort ist F2 maximal) $F2 = 0.5 \cdot (\chi_3 - \chi_2)$. Setzt man für die Probensuszeptibilität den typischen Wert $\chi_3 = -10 \cdot 10^{-6}$ ein, so beträgt für den Fall einer 10%-igen Abweichung der Behältersuszeptibilität $\chi_2$ von der Probensuszeptibilität $\chi_3$ das Maximum von F2 gerade $max(F2) = 0.5 \cdot 10^{-6}$. Relative Feldänderungen, welche diese Größe überschreiten, sind mit klassischen Designs inakzeptabel und brauchen eine Kompensation.

Für eine Bewertung der Inhomogenität des Feldes spielt nicht nur die stärkste Abweichung vom Mittelwert ein Rolle, sondern es muss auch die Gesamtsituation im Probenvolumen V beurteilt werden. Die geeignete Größe ist die Standardabweichung der relativen Feldänderung im Probenvolumen:

$$\sqrt{\int_V (F1 + F2)^2 \, dV}$$

Die Inhomogenität ist durch die Kompensationswirkung von F1 dann wesentlich reduziert, wenn die Standardabweichung der kombinierten relativen Feldabweichungen (F1+F2) kleiner ist als die Standardabweichung der relativen Feldänderung F3 der inneren Grenzfläche für die Probenflüssigkeit allein:

$$\sqrt{\int_V (F1 + F2)^2 \, dV} \leq 0.9 \cdot \sqrt{\int_V (F3)^2 \, dV}$$

Eine ideale Kompensation würde die Standardabweichung von (F1+F2) zum Verschwinden bringen.

Für bestimmte Anwendungen kann es wichtig sein, dass die stärkste Abweichung vom Mittelwert des Feldes einen bestimmten kritischen Wert nicht überschritten werden darf. In diesen Fällen kann die Kompensation so eingestellt werden, dass eine Bedingung der Art

$$|F1 + F2| \leq 0.5 \cdot 10^{-6}$$

an allen Punkten im Probenvolumen erfüllt wird.

3.2. Neue Aspekte der Erfindung

1. Die äußere Grenzfläche des Probenbehälters wird im Gegensatz zum Stand der Technik nicht möglichst weit weg positioniert, sondern in der Nähe der inneren Grenzfläche dazu eingesetzt, durch ihre Form und den Suszeptibilitätssprung zur Umgebung einen Feldverlauf im Probenvolumen zu erzeugen, der in Kombination mit der von der inneren Grenzfläche verursachten Feldinhomogenität gerade ein homogenes Feld ergibt.

2. Materialien mit so weit auseinanderliegenden Suszeptibilitäten wie Wasser und Quarzglas dürfen eine Grenzfläche in unmittelbarer Nähe der HF-Spule bilden, ohne dass dabei die Qualität des NMR-Spektrums verringert würde.

3. Die technisch anspruchsvolle Herstellung eines Behälters mit gleicher Suszeptibilität wie die zu untersuchende Probensubstanz durch Beimischen einer stark paramagnetischen Substanz kann ersetzt werden durch die technisch einfacher zu realisierende Formgebung des Probenbehälters z. B. durch Schleifen. Ausgehend vom immer gleichen Rohmaterial können Probenbehälter passend zu Lösungsmitteln mit verschiedenen Suszeptibilitäten hergestellt werden.

**4. Beispiele für erfindungsgemäße Probenbehälter**

Schon mit relativ einfachen Approximationen lassen sich gute Ergebnisse erzielen. Wir wollen uns daher auf einfache Geometrien beschränken, um den Effekt dieser Idee zu zeigen. Wir benutzen dazu die Tatsache, dass die Größe des Feldes innerhalb eines Ellipsoides als geschlossene Funktion existiert.

Wird ein Körper mit der Form eines Rotationsellipsoids mit Rotationsachse parallel zur z-Achse und homogener magnetischer Suszeptibilität $\chi$ in ein externes, homogenes Magnetfeld $\vec{B_0}$ = (0,0, $B_0$) parallel zur z-Achse gebracht, so ist das Magnetfeld im Innern des Körpers homogen und die z-Komponente des resultierenden Feldes im Innern des Körpers kann geschrieben werden als

$$B_z = B_0\left(1 + \chi g\right) \qquad\qquad (1)$$

wobei g ein Geometriefaktor ist, der durch das Verhältnis der Halbachsen des Rotationsellipsoids festgelegt ist [3].

Illustrativ sind die folgenden drei Beispiele von Rotationsellipsoiden: Bei einer Platte, welche in den beiden Richtungen senkrecht zum externen Feld unendliche Ausdehnung hat, ist das Feld im Innern der Platte unabhängig von der Suszeptibilität gleich dem externen Feld, d. h. g=0. Ein langer, dünner Zylinder parallel zum externen Feld hat ein inneres Feld entsprechend seiner Suszeptibilität: $B_z = B_0(1+\chi)$, d. h. g=1. in einer Kugel kommt die Suszeptiblität nicht vollständig zum Tragen, es gilt g=2/3.

Gemäss Ulrich et al. [6] und Osborn [7] lässt sich für ein Rotationsellipsoid mit Halbachsen $a_x = a_y$ und $a_z = qa_x$ der Geometriefaktor g als Funktion von q schreiben:

$$g(q) = 1 - \frac{q \cdot \ln\left(q + \sqrt{q^2 - 1}\right)}{\left(q^2 - 1\right)^{3/2}} + \frac{1}{q^2 - 1} \qquad\qquad (2)$$

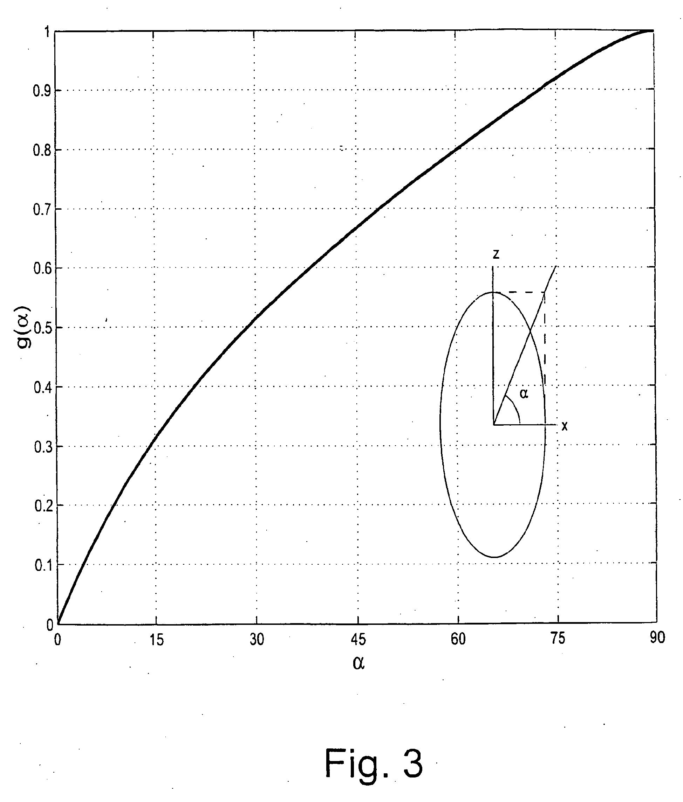

Diese Funktion ist reell für $q \in [0,\infty[$ und hat eine hebbare Singularität bei q=1. Es gilt $g(1) = 2/3$. In Figur 3 wird g als Funktion des Formwinkels (engl. *aspect angle*) $\alpha$ des Rotationsellpsoids dargestellt. Dabei ist der Zusammenhang zwischen dem Formwinkel und dem Verhältnis der Halbachsen definiert durch $\tan\alpha = q = \dfrac{a_z}{a_x}$.

### 4.1. Abschluss eines zylindrischen Probenbehälters durch ein Rotationsellipsoid

Probenbehälter für NMR Spektroskopie sind aufgrund der Probenkopfgeometrie und Vorrichtungen zur Rotation des Behälters mit Vorteil auf einem langen Abschnitt zylindrisch. Eine Freiheit, die beim Design bleibt, ist die Wahl der Form des Probenbehälterendes. Es bietet sich an, den zylindrischen Teil in ein langgezogenes Rotationsellipsoid übergehen zu lassen. Das Magnetfeld im Innern eines solchen Probenbehälters ist allerdings nicht mehr homogen. Insbesondere in der Nähe des Übergansbereichs vom Zylinder zum Rotationsellipsoid ändert sich das Magnetfeld in Abhängigkeit der Position relativ stark. Figur 4. b zeigt den Feldstärkeverlauf auf der Achse eines Körpers mit einer solchen Geometrie. Der Feldstärkeverlauf auf der Achse eines durch ein Rotationsellipsoid abgeschlossenen zylindrischen Körpers lässt sich im Wesentlichen durch drei Parameter charakterisieren:

1. Die z-Position mit dem steilsten Feldgradienten. Diese Position ist durch die Stelle gegeben, an der die zylindrische Oberfläche in die elliptische Oberfläche übergeht. Die z-Achse in der Figur ist so gewählt, dass an dieser Position z=0 gilt.

2. Die Ausdehnung des Übergangsbereichs in z-Richtung. Diese Größe skaliert mit dem Zylinderradius (41 in Fig. 4. b).

3. Die Differenz zwischen der Feldstärke im Ellipsoid und der Feldstärke im zylindrischen Teil (42 in Fig. 4. b).

Die Feldstärke auf der Symmetrieachse direkt hinter dem Sprung ist etwa der aus Formel 1 gegeben, wogegen die Feldstärke im zylindrischen Teil nur durch den Suszeptibilitätssprung $\chi$ von innerhalb zu außerhalb des Körpers gegeben ist.

4.2 Eine Anpassungs-Bedingung für Probensubstanz und Probenbehälter

Das Feld im Innern der Probensubstanz wird homogen, wenn die Inhomogenitäten, welche durch die beiden Grenzflächen verursacht werden, gerade entgegengesetzt gleich sind.

Im speziellen Fall, bei dem die beiden Grenzflächen durch ein Rotationsellipsoid abgeschlossene Zylinder sind, führen die oben erwähnten drei Parameter dazu, dass die folgenden Bedingungen erfüllt sein müssen:

1. Der Übergang auf das Ellipsoid muss für die innere Grenzfläche und die äußere Grenzfläche an der gleichen z-Position erfolgen (d.h. maximale Steigung an der gleichen Position)

2. Die senkrecht zur Rotationsachse stehende Radien der beiden Grenzflächen (Zylinderradius und Halbachse $a_x$) dürfen sich nur wenig unterscheiden, d. h. der Übergangsbereich ist vergleichbar groß.

3. Die Differenz, d.h. der dritte Parameter, der beiden Grenzflächen muss gleich und mit entgegengesetztem Vorzeichen auftreten. Dies führt zur Anpassungsbedingung

$$(\chi_2 - \chi_1)(1 - g(\alpha_1)) = -(\chi_3 - \chi_2)(1 - g(\alpha_2)) \qquad (3)$$

Mit $\chi_1 = 0$ (Vakuum oder Stickstoff außen) gilt für das Verhältnis der Suszeptibilitäten:

$$\frac{\chi_2}{\chi_3} = \frac{1 - g(\alpha_2)}{g(\alpha_1) - g(\alpha_2)} \qquad (4)$$

Das Ellipsoid 2 muss überall im Innern von Ellipsoid 1 liegen, somit folgt $0 < \alpha_2 \leq \alpha_1 < 90°$. Aus der Monotonie von g folgt $0 \leq g(\alpha_2) < g(\alpha_1) \leq 1$. Damit ist sowohl $(1-g(\alpha_2)) > 0$ als auch $(g(\alpha_1) - g(\alpha_2)) > 0$, d. h. die Vorzeichen von $\chi_2$ und $\chi_3$ müssen identisch sein, damit die Anpassungs-Bedingung erfüllt werden kann. Außerdem muss

$$|\chi_2| \geq |\chi_3| \qquad (5)$$

erfüllt sein, d. h. für den Probenbehälter kommen nur betragsmäßig größere Suszeptibilitäten als diejenige der Probensubstanz in Frage.

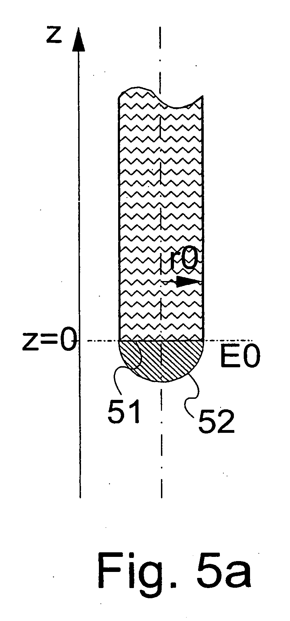

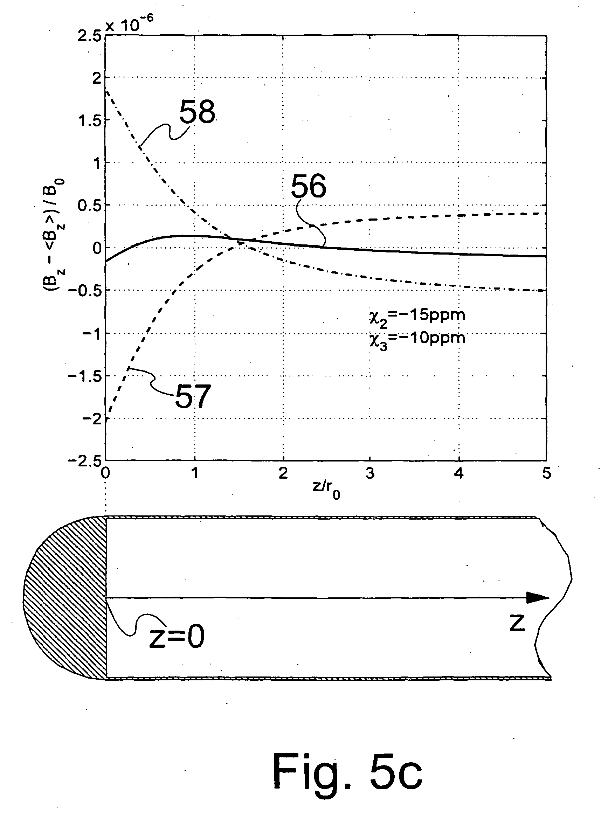

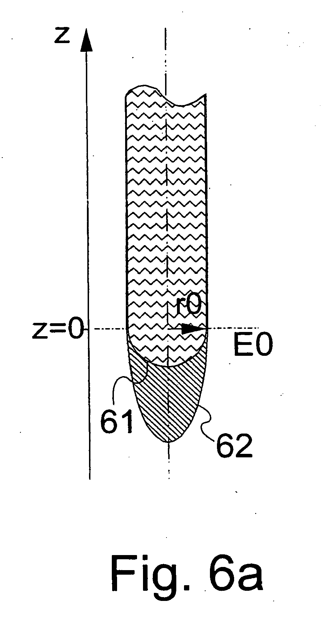

Die folgenden Beispiele zeigen, wie alleine durch die Anwendung der einen Gleichung der Anpassungs-Bedingung bereits eine Kompensation unter die in [2] geforderte Inhomogenität erreicht werden kann. Die berechneten Feldverläufe in den Bildern Fig. 5a-c und Fig. 6a-c sind mit der Methode der äquivalenten Stromdichte bestimmt worden, um zu zeigen, wie gut diese einfache Approximation bereits funktioniert.

Beispiel 1: stumpfes Ende innen (flacher Boden)

Möchte man das Volumen der Probensubstanz möglichst scharf an der Grenze der HF-Spule begrenzen, so ist ein stumpfes Ende der inneren Grenzfläche wünschenswert. Es sei also $\alpha_2 = 0$ und somit $g(\alpha_2)= 0$. Damit ist die Anpassungs-Bedingung

$$\chi_2 = \frac{1}{g(\alpha_1)} \chi_3 \qquad (6)$$

und für den Fall einer Halbkugel (d. h. $\alpha_1 = 45°$) außen folgt: $\chi_2 = \frac{3}{2} \chi_3$ . Eine Feinkorrektur zur optimalen Anpassung des Probenbehälters an eine Probensubstanz kann durch eine technisch einfach zu realisierende Korrektur an der Form der Außenfläche (also am Faktor $g(\alpha_1)$) erfolgen.

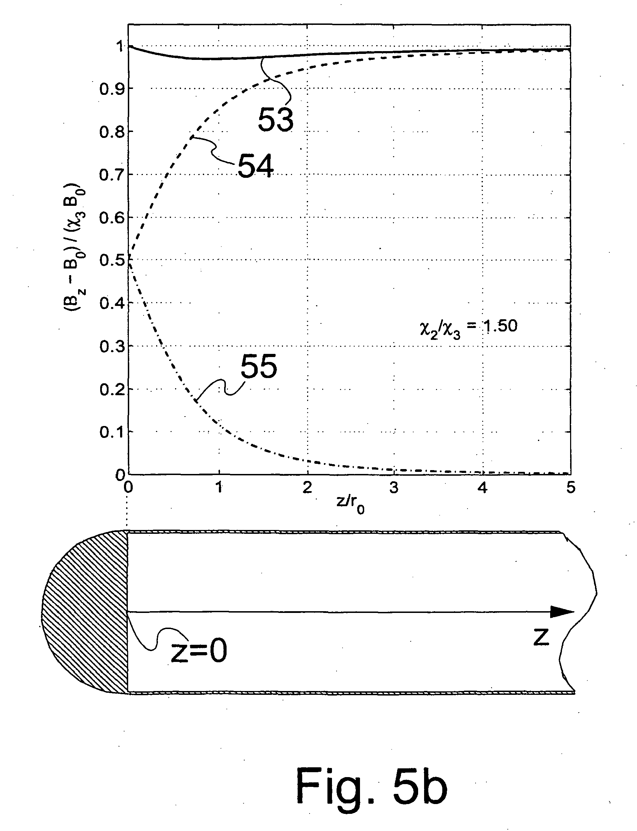

In Figur 5b wird der Feldverlauf im Probenvolumen gezeigt, der bei Erfüllen dieser Anpassungs-Bedingung erreicht werden kann (53). Im Vergleich dazu wird der Feldverlauf dargestellt, der sich ohne Anpassung der äußeren Grenzfläche (technisch durch einen überall dünnwandigen Probenbehälter realisierbar) einstellen würde (54).

In [2] wird für die beiden Suszeptibilitäten an einer stumpfen Grenzfläche gefordert, dass ihre Differenz weniger als 10% der Probensuszeptibilität ausmachen darf, damit die resultierende Feldinhomogenität mit Hilfe von Shimspulen kompensiert werden kann. Im vorliegenden Beispiel einer erfindungsgemäßen Anordnung kompensiert die halbkugelförmige Außenfläche einen Suszeptibilitätssprung von 50% der Probensuszeptibilität: Auf diese Weise ist die Kombination von Materialien mit viel weiter auseinanderliegender Suszeptibilität möglich!

Beispiel 2: Halbkugel innen

Im Fall einer Halbkugel als Abschluss der Innenfläche gilt $\alpha_2 = 45°$ und somit $g(\alpha_2) = \dfrac{2}{3}$. Damit ist die Anpassungs-Bedingung

$$\chi_2 = \frac{1}{3g(\alpha_1)-2}\chi_3 \qquad\qquad (7)$$

Wählt man z. B. $\chi_2 = \dfrac{3}{2}\chi_3$, dann ist die Anpassungs-Bedingung für $\alpha_1 \approx 71°$ erfüllt, d. h. $q \approx 3$.

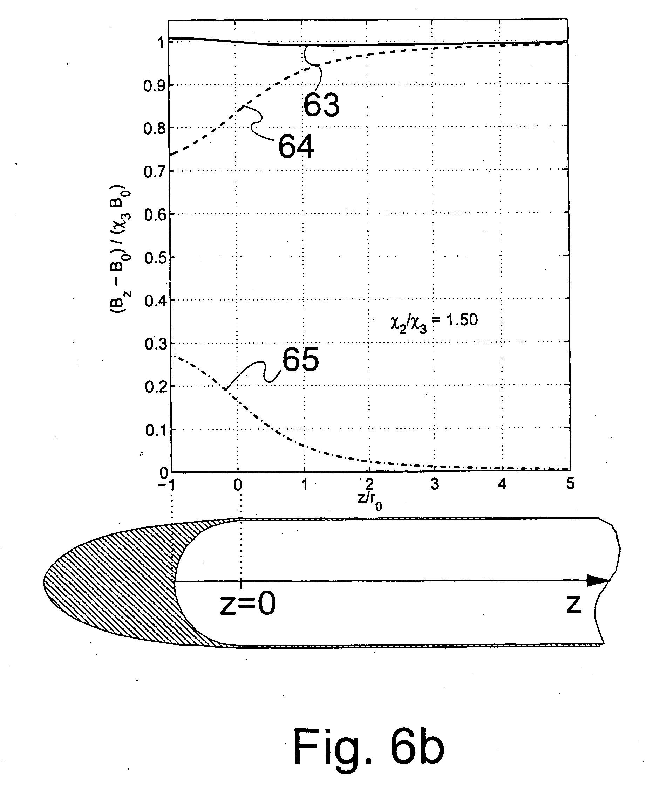

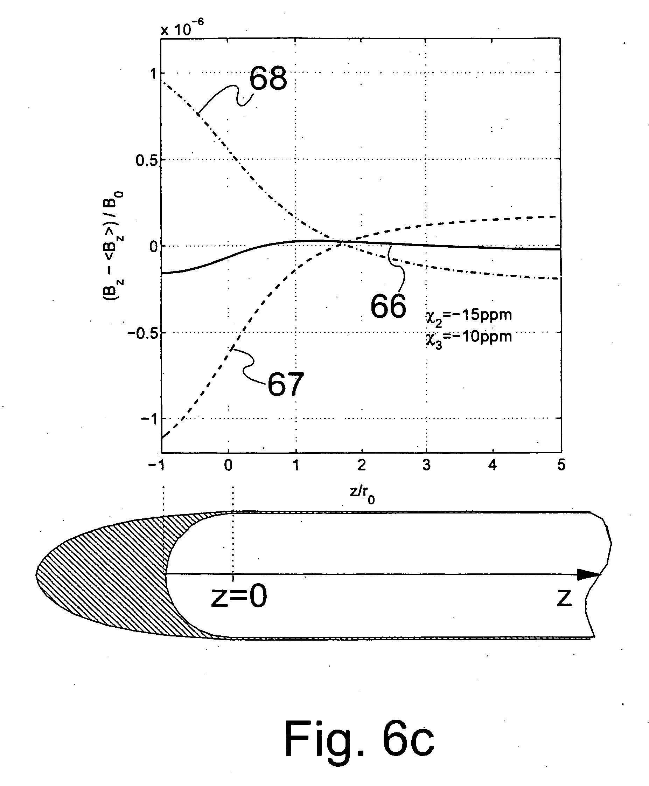

In Figur 6 wird der Feldverlauf im Probenvolumen gezeigt, der bei Erfüllen dieser Anpassungs-Bedingung erreicht werden kann. Im Vergleich dazu wird der Feldverlauf dargestellt, der sich ohne Anpassung der äußeren Grenzfläche (technisch durch einen überall dünnwandigen Probenbehälter realisierbar) einstellen würde.

Typische Suszeptibilitätswerte

In der hochauflösenden NMR-Spektroskopie werden häufig in Wasser gelöste Substanzen untersucht. Ein weiteres häufig verwendetes Lösungsmittel ist Aceton. Für die Herstellung der Samplebehälter ist Borosilikatglas besonders gut geeignet. Quarzglas wird ebenfalls verwendet. Die Suszeptibilitätswerte dieser Substanzen sind:

Wasser: $-9.05 \cdot 10^{-6}$
Aceton: $-5.80 \cdot 10^{-6}$
Borosilikatglas: $-11.0 \cdot 10^{-6}$
Quarzglas: $-15.0 \cdot 10^{-6}$

Wählt man z. B. für die Innenfläche ein stumpfes Ende, dann erhält man durch Einsetzen der Suszeptibilitätswerte in Formel 7 die folgenden Formwinkel des äußeren Ellipsoids, bei denen das Feld homogen wird. Je nach Kombination von Lösungsmittel mit Material des Probenbehälters ergibt das:

Wasser/Borosilikatglas: 63°
Aceton/Borosilikatglas: 32°
Wasser/Quarzglas: 38°
Aceton/Quarzglas: 20°.

Palette von Samplebehältern

Wenn nun in einem NMR-Labor verschiedene Lösungsmittel zur Anwendung kommen, besteht die Möglichkeit, eine Anzahl Probenbehälter zur Verfügung zu stellen, wobei die Probenbehälter aus demselben Material bestehen aber unterschiedliche Formen aufweisen, und für jede Messung passend zur magnetischen Suszeptibilität $\chi_2$ der Probensubstanz der geeignete Typ von Probenbehälter gewählt wird, so dass die resultierende Feldinhomogenität minimal bleibt.

4.3. Lösung durch äquivalente Stromdichte

Der Einfluss einer beliebig geformten Grenzfläche auf das Magnetfeld kann folgendermaßen modelliert werden:
Das Koordinatensystem sei so definiert, dass das externe Magnetfeld $B_0$ nur eine z-Komponente besitzt. Man zerlegt das Gebiet, in dem die zwei Materialien liegen, in Scheiben der Dicke dz. In jeder Scheibe senkrecht zum $B_0$ verläuft nun eine begrenzende Kontur in der x-y-Ebene. Entlang dieser Kontur fließe ein Strom

$$I = \frac{B_0}{\mu_0}\left(\chi_i - \chi_a\right)\cdot dz$$

wobei $\chi_i$ die Suszeptibilität des gänzlich innerhalb der Kontur liegenden Materials ist und $\chi_a$ die Suszeptibilität des anderen Materials ist und positives Vorzeichen des Stroms durch den positiven Drehsinn bezüglich der z-Achse gegeben ist. Das durch die so bestimmten Ströme erzeugte Magnetfeld kann für beliebige Punkte im Raum durch das Anwenden der Biot-Savart-Gleichung berechnet werden.
Die in den Figuren 4, 5 und 6 dargestellten Verläufe der z-Komponente des Magnetfeldes wurden auf diese Weise für Punkte auf der Rotationsachse berechnet.

## 5. Erklärungen zu den Figuren

**Fig. 1 :**
Längsschnitt durch die typische Form eines in der hochauflösenden NMR-Spektroskopie verwendeten Probenbehälters (11), der mit einer Probensubstanz (12) gefüllt ist. Die dreidimensionale Geometrie des Behälters muss man sich rotationssymmetrisch zur strichpunktiert eingezeichnet Achse denken. Radial außerhalb des Probenbehälters ist ein Schnitt durch die HF-Spule (13) angedeutet. Die Ausdehnung der HF-Spule in Längsrichtung bestimmt den Volumenanteil (14) der zu untersuchenden Flüssigkeit, der einen Beitrag zum NMR-Signal liefert. Die Ausdehnung dieses Volumenanteils (Messbereichs) (14) ist durch eine gestrichelte Linie angedeutet. Die hier gezeigte Form des Probenbehälters wird dann verwendet, wenn eine ausreichende Menge an Probensubstanz zur Verfügung steht.
**Fig. 2 :**
Längsschnitt durch bekannte Probenbehälter, welche ein reduziertes Flüssigkeitsvolumen erlauben ohne dabei eine Magnetfeldinhomogenität innerhalb des Probenvolumens zu verursachen.
**Fig. 2a :**
Probenbehälter gemäss dem Patent von Shigezane. Die magnetische Suszeptibilität des Behälters (21) und des Verschlusses (22) sind so gewählt, dass sie gerade der magnetischen Suszeptibilität der Probensubstanz (23) entsprechen.
**Fig. 2b :**
Probenbehälter gemäss dem Patent von Fujita. Das Probenvolumen bildet eine kugelförmige Grenzfläche (24) mit dem Behälter.
**Fig. 2c :**
Probenbehälter mit einem unteren (25) und einem oberen (26) Verdrängungskörper, gemäss dem Patent von Cummings. Die beiden Verdrängungskörper bilden gegenüber der Probensubstanz eine Grenzfläche in Form eines Rotationsellipsoids (27). Die beiden Verdrängungskörper können in einen konventionellen Probenbehälter (28) eingesetzt werden.
**Fig. 3** :
Der magnetische Geometrie-Faktor g für ein Rotationsellipsoid in Abhängigkeit vom Formwinkel $\alpha$. Die in das Diagramm eingefügte Zeichnung illustriert die Definition des Winkels $\alpha$. Die mit z beschriftete Achse ist die Rotationsachse.
**Fig. 4 :**
Relative Feldänderung verursacht durch eine Grenzfläche mit einem Suszeptibilitätssprung $\chi$ zwischen innen und außen. Die Grenzfläche ist auf einem Abschnitt durch einen Zylinder und auf einem anderen Abschnitt durch ein Rotationsellipsoid definiert.
**Fig. 4a :**
Längsschnitt durch den Rotationskörper. $z = 0$ ist die Stelle in z-Richtung, an der die beiden Geometrien ineinander übergehen. Der dem Zylinder und dem Rotationsellipsoid gemeinsame Radius ist mit $r_0$ bezeichnet.
**Fig. 4b :**

Die relative Feldänderung $(B_z - B_0)/(\chi B_0)$ auf der Achse des Rotationskörpers. (41) deutet die Ausdehnung des Übergangsbereichs zwischen dem Feld im Zylinder und dem Feld im Rotationsellipsoid an, (42) bezeichnet die Differenz zwischen der Feldstärke weit im Ellipsoid drin und der Feldstärke im zylindrischen Teil.

**Fig. 5 :**

Ein Beispiel für eine erfindungsgemäße Kombination von innerer und äußerer Grenzfläche des Probenbehälters. Im vorliegenden Beispiel wird unterhalb der Ebene E0 ein stumpfer Abschluss der inneren Fläche (51) und ein halbkugelförmiger Abschluss (d. h. ein Formwinkel von 45 Grad) der äußeren Fläche (52) gewählt.

**Fig. 5a :**

Längsschnitt durch den Probenbehälter und die Probensubstanz. Links neben der Grafik sind Nullpunkt und Richtung der z-Achse, wie sie in Figur 5b verwendet werden, eingezeichnet.

**Fig. 5b :**

Die simulierte, relative Feldänderung $(B_z - B_0)/(\chi_3 B_0)$ im Innern des Probenvolumens für den Fall, dass die Suszeptibilität der Probensubstanz und des Probenbehälters die Anpassungs-Bedingung aus Gleichung 6 erfüllen, dass die Suszeptibilität der Umgebung $\chi_1 = 0$ und dass das Verhältnis der Suszeptibilitäten $\dfrac{\chi_2}{\chi_3} = \dfrac{3}{2}$ beträgt

(53). Das Feld wurde auf der Achse des

Probenbehälters berechnet. Zum Vergleich ist die relative Feldänderung auch für den Fall eingezeichnet, bei dem nur die Probensubstanz einen Beitrag zur Feldänderung leistet (54, auch bezeichnet als F3) und ebenso für den Fall, dass nur der leere Probenbehälter einen Beitrag zur Feldänderung leistet (55). Die Feldinhomogenitäten von (54) und (55) sind im Wesentlichen entgegengesetzt gleich, so dass sich in der Kombination (53) ein weitgehend homogenes Feld ergibt.

**Fig. 5c :**

Die relativen, auf ihren Mittelwert bezogenen Feldänderungen F1, F2 und (F1+F2), welche durch die äußere und innere Grenzfläche des Beispiels aus Fig. 5b verursacht werden. Für die Suszeptibilitäten wurden die folgenden Werte gewählt: $\chi_1 = 0$ , $\chi_2 = -15\ ppm,\ \chi_3 = -10\ ppm.$

(56) : die resultierende Feldänderung (F1+F2)

(57) : die Feldänderung F2, welche durch die innere Grenzfläche verursacht wird

$$F2 = (B_z^{(2)} - \langle B_z^{(2)} \rangle) / B_0$$

(58) : die Feldänderung F1, welche durch die äußere Grenzfläche verursacht wird

$$F1 = (B_z^{(1)} - \langle B_z^{(1)} \rangle) / B_0$$

**Fig. 6 :**

Ein weiteres Beispiel für eine erfindungsgemäße Kombination von innerer und äußerer Grenzfläche des Probenbehälters. Im vorliegenden Beispiel wird unterhalb der Ebene E0 ein halbkugelförmiger Abschluss der inneren Fläche (61) und ein Abschluss der äußeren Fläche in Form eines langgezogenen Rotationsellipsoids (62) gewählt.

**Fig. 6a :**

Längsschnitt durch den Probenbehälter und die Probensubstanz. Das äußere Rotationsellipsoid hat einen Formwinkel von ca. 71 Grad. Links neben der Grafik sind Nullpunkt und Richtung der z-Achse, wie sie in Figur 6b verwendet werden, eingezeichnet.

**Fig. 6b :**

Die simulierte, relative Feldänderung $(B_z - B_0)/(\chi_3 B_0)$ im Innern des Probenvolumens für den Fall, dass die Suszeptibilität der Probensubstanz und des Probenbehälters die Anpassungs-Bedingung aus Gleichung 7 erfüllen und dass das Verhältnis der Suszeptibilitäten $\dfrac{\chi_2}{\chi_3} = \dfrac{3}{2}$ beträgt (63). Das Feld wurde auf der Achse des Probenbehälters berechnet. Zum Vergleich ist die relative Feldänderung auch für die Fälle eingezeichnet, bei dem nur die Probensubstanz einen Beitrag zur Feldänderung leistet (64, auch bezeichnet mit F3) und bei dem nur der leere Probenbehälter einen Beitrag zur Feldänderung leistet (65). Die Feldinhomogenitäten von (64) und (65) sind im Wesentlichen entgegengesetzt gleich, so dass sich in der Kombination (63) ein weitgehend homogenes Feld ergibt.

**Fig. 6c**
Die relativen, auf ihren Mittelwert bezogenen Feldänderungen F1, F2 und (F1+F2), welche durch die äußere und innere Grenzfläche des Beispiels aus Fig. 6b verursacht werden. Für die Suszeptibilitäten wurden die folgenden Werte gewählt: $\chi_1 = 0$, $\chi_2 = -15$ *ppm*, $\chi_3 = -10$ *ppm.* (66) : die resultierende Feldänderung (F1+F2)
(67) : die Feldänderung F2, welche durch die innere Grenzfläche verursacht wird

$$F2 = (B_z^{(2)} - < B_z^{(2)} >) / B_0$$

(68) : die Feldänderung F1, welche durch die äußere Grenzfläche verursacht wird

$$F1 = (B_z^{(1)} - < B_z^{(1)} >) / B_0$$

**Fig. 7:**
Gebiete und Grenzflächen für die allgemeine Aufgabenstellung:

(71): $\Omega_1$, Umgebung mit Suszeptibilität $\chi_1$
(72): $\Omega_2$, Behälter mit Suszeptibilität $\chi_2$
(73): $\Omega_3$, Probensubstanz mit Suszeptibilität $\chi_3$
(74): $G_1$, Grenzfläche zwischen $\Omega_1$ und $\Omega_2$
(75): $G_2$, Grenzfläche zwischen $\Omega_2$ und $\Omega_3$

**Fig. 8**
Gebiete und Grenzflächen bei einem erfindungsgemäßen Probenbehälter (vgl. auch Probenbehälter von Fig. 6a). Ein erfindungsgemäßer NMR-Probenbehälter 80 besteht aus einem Behältermaterial 86 mit der magnetischen Suszeptibilität $\chi_2$. Zu einem innen liegenden Probenvolumen 88 hin, welches mit einer flüssigen NMR-Probe 87 einer magnetischen Suszeptibilität χ3 gefüllt ist, wird der Behälter durch eine innere Grenzfläche G2 begrenzt. Nach außen, also zu einer Umgebung 85 mit magnetischer Suszeptibilität χ1 hin, wird der Probenbehälter 80 durch eine äußere Grenzfläche G1 begrenzt. Die äußere Grenzfläche G1 umfasst eine äußere Zylinderfläche 81 und eine äußere Abschlussfläche 82. Die innere Grenzfläche G2 umfasst eine innere Zylinderfläche 83 und eine innere Abschlussfläche 84. Der NMR-Probenbehälter 80 ist rotationssymmetrisch aufgebaut und weist im gezeigten Beispiel einen kreisförmigen Querschnitt auf. Bei einer NMR-Messung werden typischerweise aus einem Messbereich 89 Signale der flüssigen Messprobe 87 aufgenommen.

**6. Literaturverzeichnis**

[1] A. P. Zens, Controlled Susceptibility Plugs. US Patent Nr. US4549136 (1985).
[2] M. Shigezane et al., Sample Tube for Nuclear Magnetic Resonance Apparatus. US Patent Nr. US5831434 (1998).
[3] J. C. Maxwell, A Treatise on Electricity and Magnetism, Dover Publications, New York, 1954, third edition, Vol. 2, pp. 66-70
[4] M. Fujita, Japanisches Patent Nr. JP6249934 (1994).
[5] M. D. Cummings, NMR Sample Shaper. US Patent Nr. US5302900 (1994).
[6] R. Ulrich et al., Susceptibility corrections in solid state NMR experiments with oriented membrane samples: Part II: Theory, J. Magn. Reson. 164, 115-127 (2003).
[7] J. A. Osborn, Demagnetizing Factors of the General Ellipsoid, Phys. Rev. 67, 351-357 (1945).
[8] J. D. Jackson, Classical Electrodynamics, John Wiley, New York, 1998, Third Edition.

**Patentansprüche**

1. Messanordnung für NMR-Messungen, umfassend einen Probenbehälter (80), eine Umgebung (85) mit einer magnetischen Suszeptibilität $\chi_1$ und eine flüssige Probe (87) mit einer magnetischen Suszeptibilität $\chi_3$, wobei der Probenbehälter (80) aus einem Behältermaterial (86) der magnetischen Suszeptibilität $\chi_2$ besteht,

mit einer äußeren Grenzfläche (G1), die den Probenbehälter (80) zur Umgebung (85) hin begrenzt,
und mit einer inneren Grenzfläche (G2), die den Probenbehälter (80) zu einem Probenvolumen (88) begrenzt,
wobei die äußere Grenzfläche (G1) umfasst

- eine äußere Zylinderfläche (81), die zylindermantelförmig ausgebildet ist und mit ihrer Längsachse parallel zu einer z-Richtung ausgerichtet ist,
- und eine äußere Abschlussfläche (82), die den Probenbehälter (80) am unteren Ende abschließt und sich an die äußere Zylinderfläche (81) anschließt,

und wobei die innere Grenzfläche (G2) umfasst

- eine innere Zylinderfläche (83), die zylindermantelförmig ausgebildet ist und mit ihrer Längsachse parallel zur z-Richtung ausgerichtet ist,
- und eine innere Abschlussfläche (84), die das Probenvolumen (88) am unteren Ende abschließt und sich an die innere Zylinderfläche (83) anschließt,

wobei der Probenbehälter (80) in der Umgebung (85) angeordnet ist und die flüssige Probe (87) im Probenvolumen (88) des Probenbehälters (80) angeordnet ist,
**dadurch gekennzeichnet,**
**dass** die äußere Grenzfläche (G1), einschließlich der Form der äußeren Abschlussfläche (82), und die innere Grenzfläche (G2), einschließlich der Form der inneren Abschlussfläche (84), so ausgebildet sind, dass bei Anlegen eines äußeren, homogenen Magnetfelds $B_0$ parallel zur z-Achse gilt:

- die äußere Grenzfläche (G1) bewirkt durch den Suszeptibilitätssprung von $\chi_1$ auf $\chi_2$ im Bereich des Probenvolumens (88) ein Feld $B_z^{(1)}$ mit einem Mittelwert im Probenvolumen $< B_z^{(1)} >$ und damit eine erste relative Feldänderung F1 = ($B_z^{(1)}$-$< B_z^{(1)} >$) / $B_0$, die zumindest in einem Teil des Probenvolumens betragsmäßig wenigstens $0.5\cdot10^{-6}$ beträgt;
- die innere Grenzfläche (G2) bewirkt durch den Suszeptibilitätssprung von $\chi_2$ auf $\chi_3$ im Bereich des Probenvolumens (88) ein Feld $B_z^{(2)}$ mit einem Mittelwert im Probenvolumen $< B_z^{(2)} >$ und damit eine zweite relative Feldänderung F2 = ($B_z^{(2)}$-$< B_z^{(2)} >$) / $B_0$, die zumindest in einem Teil des Probenvolumens betragsmäßig wenigstens $0.5\cdot10^{-6}$ beträgt,
- die erste relative Feldänderung F1 und die zweite relative Feldänderung F2 heben sich im Probenvolumen (88) V im Wesentlichen auf, so dass gilt

$$\sqrt{\int_V (F1+F2)^2\, dV} \leq 0.9 \cdot \sqrt{\int_V (F3)^2\, dV}$$

wobei die innere Grenzfläche (G2), wenn nur die durch die innere Grenzfläche (G2) begrenzte flüssige Probe (87) allein und der Probenbehälter nicht vorhanden wäre, durch einen Suszeptibilitätssprung von $\chi_1$ auf $\chi_3$ im Bereich des Probenvolumens (88) ein Feld $B_z^{(3)}$ mit einem Mittelwert im Probenvolumen $< B_z^{(3)} >$ und damit eine dritte relative Feldänderung F3 = ($B_z^{(1)}$-$< B_z^{(3)} >$) / $B_0$ bewirken würde.

2. Messanordnung nach Anspruch 1, **dadurch gekennzeichnet, dass** gilt

$$\sqrt{\int_V (F1+F2)^2\, dV} \leq 0.5 \cdot \sqrt{\int_V (F3)^2\, dV} \,,$$

und insbesondere dass gilt $\sqrt{\int_V (F1+F2)^2\, dV} \leq 0.1 \cdot \sqrt{\int_V (F3)^2\, dV}$ .

3. Messanordnung nach einem der vorhergehenden Ansprüche, **dadurch gekennzeichnet, dass** überall im Probenvolumen (88) gilt

$$|F1 + F2| \leq 0.5 \cdot 10^{-6} \,,$$

und insbesondere dass gilt $|F1 + F2| \leq 0.1 \cdot 10^{-6}$.

4. Messanordnung nach einem der vorhergehenden Ansprüche, **dadurch gekennzeichnet, dass** gilt:

$\chi_2\chi_3 > 0$ und $|\chi_2| > |\chi_3|$, insbesondere wobei $|\chi_2|/|\chi_3| > 1.1$.

5. Messanordnung nach einem der vorhergehenden Ansprüche, **dadurch gekennzeichnet, dass** der Probenbehälter (80) aus Borosilikatglas oder Quarzglas gefertigt ist.

6. Messanordnung nach einem der vorhergehenden Ansprüche, **dadurch gekennzeichnet, dass** die Umgebung (85) Luft, Stickstoffgas oder ein Edelgas, insbesondere Argon, ist.

7. Messanordnung nach einem der vorhergehenden Ansprüche, **dadurch gekennzeichnet, dass** ein Lösungsmittel der flüssigen Probe (87) Wasser oder Aceton ist.

8. Messanordnung nach einem der vorhergehenden Ansprüche, **dadurch gekennzeichnet, dass** der Probenbehälter (80) bezüglich der z-Richtung rotationssymmetrisch ausgebildet ist.

9. Messanordnung nach einem der vorhergehenden Ansprüche, **dadurch gekennzeichnet,**
**dass** die äußere Abschlussfläche (82) und die innere Abschlussfläche (84) jeweils als Halbellipsoide ausgebildet sind, wobei ein Halbellipsoid **dadurch** definiert ist, dass ein Rotationsellipsoid senkrecht zu seiner Rotationsachse halbiert ist,
**dass** die äußere Grenzfläche (G1) und die innerer Grenzfläche (G2) jeweils bei gleicher Position in z-Richtung von der Abschlussfläche (82, 84) in die Zylinderfläche (81, 83) übergehen, und dass näherungsweise gilt:

$$\left(\chi_2 - \chi_1\right)\!\left(1 - g(\alpha_1)\right) = -\left(\chi_3 - \chi_2\right)\!\left(1 - g(\alpha_2)\right),$$

wobei
$\alpha_1$ = Formwinkel des Halbellipsoides der äußeren Abschlussfläche (82),
$\alpha_2$ = Formwinkel des Halbellipsoides der inneren Abschlussfläche (84),

$$g(\alpha_1) = 1 - \frac{\tan(\alpha_1) \cdot \ln\!\left(\tan(\alpha_1) + \sqrt{\tan(\alpha_1)^2 - 1}\right)}{\left(\tan(\alpha_1)^2 - 1\right)^{3/2}} + \frac{1}{\tan(\alpha_1)^2 - 1},$$

$$g(\alpha_2) = 1 - \frac{\tan(\alpha_2) \cdot \ln\!\left(\tan(\alpha_2) + \sqrt{\tan(\alpha_2)^2 - 1}\right)}{\left(\tan(\alpha_2)^2 - 1\right)^{3/2}} + \frac{1}{\tan(\alpha_2)^2 - 1}.$$

10. Messanordnung nach Anspruch 9, **dadurch gekennzeichnet, dass** gilt

$$\left(\chi_2 - \chi_1\right)\!\left(1 - g(\alpha_1)\right) = -\left(\chi_3 - \chi_2\right)\!\left(1 - g(\alpha_2)\right) \cdot U \,,$$

mit $0.95 \leq U \leq 1{,}05$, insbesondere $0{,}99 \leq U \leq 1{,}01$.

11. Messanordnung nach einem der vorhergehenden Ansprüche, **dadurch gekennzeichnet, dass** die innere Abschlussfläche (84) und die äußere Abschlussfläche (82) in z-Richtung einen maximalen Abstand von 3 mm aufweisen.

**12.** Verfahren zur Bestimmung der Gestalt der äußeren und inneren Grenzfläche (G1, G2), einschließlich der Form der Abschlussflächen (82, 84), einer Messanordnung gemäß einem der vorhergehenden Ansprüche, **gekennzeichnet durch** folgende Schritte:

- Festlegen von Parametern, welche die Form der Grenzflächen (G1, G2), einschließlich der Form der Abschlussflächen (82, 84), definieren;
- Festlegen einer Kostenfunktion, welche zu jeder Kombination von Parametern berechnet werden kann und so konstruiert ist, dass kleinere Werte der Kostenfunktion eine Verbesserung der Feldhomogenität des Magnetfelds im Probenvolumen (88) bei Anlegen des äußeren, homogenen Magnetfelds $B_0$ beschreiben, wobei die Kostenfunktion unter anderem einen Term der Form

$$\sim \sqrt{\int_V (F1 + F2)^2 \, dV}$$

enthält, wobei F1, F2 und V definiert sind wie im Anspruch 1;
- Anwenden eines numerischen Optimierungsalgorithmus zur Bestimmung eines Satzes von Parametern, welche ein Minimum der Kostenfunktion festlegen.

**Claims**

**1.** Measurement configuration for MNR measurements, comprising a sample vessel (80), an environment (85) with a magnetic susceptibility $\chi_1$, and a liquid sample (87) with a magnetic susceptibility $\chi_3$, wherein the sample vessel (80) consists of a vessel material (86) of a magnetic susceptibility $\chi_2$,
with an outer interface (G1) that limits the sample vessel (80) with respect to the environment (85),
and with an inner interface (G2) that limits the sample vessel (80) with respect to a sample volume (88),
the outer interface (G1) comprising

- an outer cylindrical surface (81) shaped as cylinder envelope with a longitudinal axis which is aligned parallel to a z-direction,
- and an outer closing surface (82) which closes the sample vessel (80) at a lower end thereof and is contiguous to the outer cylindrical surface (81),

and wherein the inner interface (G2) comprises

- an inner cylindrical surface (83) shaped as cylinder envelope with a longitudinal axis which is aligned parallel to the z-direction,
- and an inner closing surface (84) which closes the sample volume (88) at a lower end thereof and is contiguous to the inner cylindrical surface (83),

wherein the sample vessel (80) is located in the environment (85) and the liquid sample (87) is located in the sample volume (88) of the sample vessel (80),
**characterized in that**
the outer interface (G1) including the shape of the outer closing
surface (82), and the inner interface (G2) including the shape of the inner closing surface (84) are designed in such a fashion that, upon application of an external homogeneous magnetic field $B_0$ parallel to the z-axis, the following applies:

- the outer interface (G1) causes, due to the jump in susceptibility from $\chi_1$ to $\chi_2$, in the region of the sample volume (88) a field $B_z^{(1)}$ with an average value in the sample volume $< B_z^{(1)} >$ and therefore a first relative field change F1 = $(B_z^{(1)} - < B_z^{(1)} >) / B_0$ that, at least in a part of the sample volume, has an absolute value of no less than $0.5 \cdot 10^{-6}$;
- the inner interface (G2) causes, due to the jump in susceptibility from $\chi_2$ to $\chi_3$, in the region of the sample volume (88) a field $B_z^{(2)}$ with an average value in the sample volume $< B_z^{(2)} >$ and therefore a second relative field change $F2 = (B_z^{(2)} - < B_z^{(2)} >) / B_0$ that, at least in a part of the sample volume, has an absolute value of no less than $0.5 \cdot 10^{-6}$,
- the first relative field change F1 and the second relative field change F2 largely cancel each other out in the sample volume (88) V so that the following applies

$$\sqrt{\int_V (F1+F2)^2 \, dV} \leq 0.9 \cdot \sqrt{\int_V (F3)^2 \, dV} \quad ,$$

wherein, if only the liquid sample (87) that is limited by the inner interface (G2) were present and not the sample vessel, the inner interface (G2) would cause, due to a jump in susceptibility from $\chi_1$ to $\chi_3$, in the region of the sample volume (88) a field $B_z^{(3)}$ with an average value in the sample volume $< B_z^{(3)} >$ and therefore a third relative field change $F3 = (B_z^{(3)} - < B_z^{(3)} >) / B_0$.

2. The measurement configuration according to claim 1, **characterized in that**

$$\sqrt{\int_V (F1+F2)^2 \, dV} \leq 0.5 \cdot \sqrt{\int_V (F3)^2 \, dV} \quad , \quad \text{and, in particular,}$$

$$\sqrt{\int_V (F1+F2)^2 \, dV} \leq 0.1 \cdot \sqrt{\int_V (F3)^2 \, dV} \quad .$$

3. The measurement configuration according to any one of the preceding claims, **characterized in that** throughout the sample volume (88)

$$|F1 + F2| \leq 0.5 \cdot 10^{-6} \, ,$$

and, in particular

$$|F1 + F2| \leq 0.1 \cdot 10^{-6}.$$

4. The measurement configuration according to any one of the preceding claims, **characterized in that** $\chi_2 \chi_3 > 0$ and $|\chi_2| > |\chi_3|$, in particular, wherein $|\chi_2|/|\chi_3| > 1.1$.

5. The measurement configuration according to any one of the preceding claims, **characterized in that** the sample vessel (80) is made of borosilicate glass or quartz glass.

6. The measurement configuration of any one of the preceding claims, **characterized in that** the environment (85) is air, nitrogen gas, or an inert gas, in particular argon.

7. The measurement configuration according to any one of the preceding claims, **characterized in that** a solvent of the liquid sample (87) is water or acetone.

8. The measurement configuration according to any one of the preceding claims, **characterized in that** the sample vessel (80) is rotationally symmetric with respect to the z-direction.

9. The measurement configuration according to any one of the preceding claims, **characterized in that** the outer closing surface (82) and the inner closing surface (84) are each constituted as a hemi-ellipsoid, wherein the hemi-ellipsoid is a spheroid halved perpendicular to an axis of revolution thereof, the outer interface (G1) and the inner interface (G2) each make a transition from said closing surface (82, 84) to said cylindrical surface (81, 83) at a same position in the z-direction,

and the following approximately applies:

$$\left(\chi_2 - \chi_1\right)\left(1 - g(\alpha_1)\right) = -\left(\chi_3 - \chi_2\right)\left(1 - g(\alpha_2)\right),$$

with
$\alpha_1$ = aspect angle of the hemi-ellipsoid of said outer closing surface (82),
$\alpha_2$ = aspect angle of the hemi-ellipsoid of said inner closing surface (84),

$$g(\alpha_1) = 1 - \frac{\tan(\alpha_1) \cdot \ln\left(\tan(\alpha_1) + \sqrt{\tan(\alpha_1)^2 - 1}\right)}{\left(\tan(\alpha_1)^2 - 1\right)^{3/2}} + \frac{1}{\tan(\alpha_1)^2 - 1},$$

$$g(\alpha_2) = 1 - \frac{\tan(\alpha_2) \cdot \ln\left(\tan(\alpha_2) + \sqrt{\tan(\alpha_2)^2 - 1}\right)}{\left(\tan(\alpha_2)^2 - 1\right)^{3/2}} + \frac{1}{\tan(\alpha_2)^2 - 1}.$$

**10.** The measurement configuration according to claim 9, **characterized in that**

$$\left(\chi_2 - \chi_1\right)\left(1 - g(\alpha_1)\right) = -\left(\chi_3 - \chi_2\right)\left(1 - g(\alpha_2)\right) \cdot U,$$

where $0.95 \leq U \leq 1.05$, in particular, $0.99 \leq U \leq 1.01$.

**11.** The measurement configuration according to any one of the preceding claims, **characterized in that** the inner closing surface (84) and the outer closing surface (82) exhibit a maximum distance of 3 mm in the z-direction.

**12.** A method for determining the shape of said outer and inner interfaces (G1, G2), including the shape of the closing surfaces (82, 84) of a measurement configuration in accordance with any one of the preceding claims, **characterized by** the following steps:

- defining parameters that determine the shape of the interfaces (G1, G2) including the shape of the closing surfaces (82, 84);
- defining a cost function that can be calculated for any combination of parameters and is constituted such that smaller values of the cost function describe an improvement in the field homogeneity of the magnetic field in the sample volume (88) when the outer homogeneous magnetic field $B_0$ is applied, wherein the cost function includes inter alia a term of the form

$$-\sqrt{\int_V (F1 + F2)^2 \, dV}$$

wherein F1, F2 and V are defined as in claim 1;
- applying a numerical optimization algorithm to determine a set of parameters that define a minimum of the cost function.

## Revendications

**1.** Dispositif de mesure pour mesures RMN, comprenant un récipient d'échantillons (80), un environnement (85) ayant une susceptibilité magnétique $\chi_1$ et un échantillon liquide (87) ayant une susceptibilité magnétique $\chi_3$, le récipient

d'échantillons (80) étant constitué d'un matériau de récipient (86) de susceptibilité magnétique $\chi_2$,
avec une surface limite extérieure (G1) qui limite le récipient d'échantillons (80) par rapport à l'environnement (85),
et avec une surface limite intérieure (G2) qui limite le récipient d'échantillons (80) par rapport à un volume d'échantillon (88),
la surface limite extérieure (G1) comprenant

- une surface cylindrique extérieure (81) qui est réalisée en forme d'enveloppe cylindrique et dont l'axe longitudinal est orienté parallèlement à une direction z,
- et une surface terminale extérieure (82) qui ferme le récipient d'échantillons (80) à l'extrémité inférieure et se raccorde à la surface cylindrique extérieure (81),

et la surface limite intérieure (G2) comprenant

- une surface cylindrique intérieure (83) qui est réalisée en forme d'enveloppe cylindrique et dont l'axe longitudinal est orienté parallèlement à la direction z,
- et une surface terminale intérieure (84) qui ferme le volume d'échantillon (88) à l'extrémité inférieure et se raccorde à la surface cylindrique intérieure (83),

le récipient d'échantillons (80) étant disposé dans l'environnement (85) et l'échantillon liquide (87) dans le volume d'échantillon (88) du récipient d'échantillons (80),
**caractérisé en ce**
**que** la surface limite extérieure (G1), y compris la forme de la surface terminale extérieure (82), et la surface limite intérieure (G2), y compris la forme de la surface terminale intérieure (84), sont réalisées de façon qu'en cas d'application d'un champ magnétique extérieur homogène $B_0$ parallèlement à l'axe z :

- la surface limite extérieure (G1) provoque en raison du saut de susceptibilité de $\chi_1$ à $\chi_2$ dans la région du volume d'échantillon (88) un champ $B_z^{(1)}$ avec une moyenne dans le volume d'échantillon $< B_z^{(1)} >$ et donc une première variation relative de champ F1 = $(B_z^{(1)} - < B_z^{(2)} >) / B_0$ qui s'élève au moins dans une partie du volume d'échantillon à au moins $0,5 \cdot 10^{-6}$ en valeur absolue ;
- la surface limite intérieure (G2) provoque en raison du saut de susceptibilité de $\chi_2$ à $\chi_3$ dans la région du volume d'échantillon (88) un champ $B_z^{(2)}$ avec une moyenne dans le volume d'échantillon $< B_z^{(2)} >$ et donc une deuxième variation relative de champ F2 = $(B_z^{(2)} - < B_z^{(2)} >) / B_0$ qui s'élève au moins dans une partie du volume d'échantillon à au moins $0,5 \cdot 10^{-6}$ en valeur absolue,
- la première variation relative de champ F1 et la deuxième variation relative de champ F2 s'annulent essentiellement dans le volume d'échantillon (88) V, de sorte qu'il s'applique

$$\sqrt{\int_V (F1+F2)^2 \, dV} \leq 0,9 \cdot \sqrt{\int_V (F3)^2 \, dV}$$

sachant que la surface limite intérieure (G2) provoquerait, si seulement l'échantillon liquide (87) limité par la surface limite intérieure (G2) était présent et le récipient d'échantillons ne l'était pas, en raison d'un saut de susceptibilité de $\chi_1$ à $\chi_3$ dans la région du volume d'échantillon (88), un champ $B_z^{(3)}$ avec une moyenne dans le volume d'échantillon $< Bz^{(3)} >$ et donc une troisième variation relative de champ F3 = $(B_z^{(3)} - < B_z^{(3)} >) / B_0$.

2. Dispositif de mesure selon la revendication 1, **caractérisé en ce qu'**il s'applique

$$\sqrt{\int_V (F1+F2)^2 \, dV} \leq 0,5 \cdot \sqrt{\int_V (F3)^2 \, dV}$$

et en particulier

$$\sqrt{\int_V (F1+F2)^2\,dV} \le 0,1 \cdot \sqrt{\int_V (F3)^2\,dV}\ .$$

3. Dispositif de mesure selon une des revendications précédentes, **caractérisé en ce qu'**il s'applique dans tout le volume d'échantillon (88)

$$|\mathrm{F1+F2}| \le 0.5{\cdot}10^{-6},$$

et en particulier $|\mathrm{F1+F2}| \le 0.1{\cdot}10^{-6}$.

4. Dispositif de mesure selon une des revendications précédentes, **caractérisé en ce qu'**il s'applique:

$\chi_2\chi_3 > 0$ et $|\chi_2| > |\chi_3|$, en particulier avec $|\chi_2|/|\chi_3| > 1{,}1$.

5. Dispositif de mesure selon une des revendications précédentes, **caractérisé en ce que** le récipient d'échantillons (80) est réalisé en verre borosilicaté ou en verre de quartz.

6. Dispositif de mesure selon une des revendications précédentes, **caractérisé en ce que** l'environnement (85) est de l'air, de l'azote gazeux ou un gaz noble, en particulier de l'argon.

7. Dispositif de mesure selon une des revendications précédentes, **caractérisé en ce qu'**un solvant de l'échantillon liquide (87) est de l'eau ou de l'acétone.

8. Dispositif de mesure selon une des revendications précédentes, **caractérisé en ce que** le récipient d'échantillons (80) est réalisé avec une symétrie de révolution par rapport à la direction z.

9. Dispositif de mesure selon une des revendications précédentes, **caractérisé en ce que** la surface terminale extérieure (82) et la surface terminale intérieure (84) sont réalisées chacune sous la forme d'un demi-ellipsoïde, un demi-ellipsoïde étant défini par le fait qu'un ellipsoïde de révolution est divisé en deux perpendiculairement à son axe de révolution,
que la surface limite extérieure (G1) et la surface limite intérieure (G2) passent chacune à la même position en direction z de la surface terminale (82, 84) à la surface cylindrique (81, 83),
et qu'il s'applique approximativement :

$$(\chi_2 - \chi_1)(1 - g(\alpha_1)) = -(\chi_3 - \chi_2)(1 - g(\alpha_2)),$$

avec
$\alpha_1$ = angle de forme du demi-ellipsoïde de la surface terminale extérieure (82),
$\alpha_2$ = angle de forme du demi-ellipsoïde de la surface terminale intérieure (84),

$$g(\alpha_1) = 1 - \frac{\tan(\alpha_1)\cdot\ln\!\left(\tan(\alpha_1)+\sqrt{\tan(\alpha_1)^2-1}\right)}{(\tan(\alpha_1)^2-1)^{3/2}} + \frac{1}{\tan(\alpha_1)^2-1},$$

$$g(\alpha_2) = 1 - \frac{\tan(\alpha_2)\cdot\ln\!\left(\tan(\alpha_2)+\sqrt{\tan(\alpha_2)^2-1}\right)}{(\tan(\alpha_2)^2-1)^{3/2}} + \frac{1}{\tan(\alpha_2)^2-1}\ .$$

10. Dispositif de mesure selon la revendication 9, **caractérisé en ce qu'**il s'applique

$$(\chi_2 - \chi_1)(1 - g(\alpha_1)) = -(\chi_3 - \chi_2)(1 - g(\alpha_2)) \cdot U$$

avec $0{,}95 \leq U \leq 1{,}05$, en particulier $0{,}99 \leq U \leq 1{,}01$.

**11.** Dispositif de mesure selon une des revendications précédentes, **caractérisé en ce que** la surface terminale intérieure (84) et la surface terminale extérieure (82) présentent une distance maximale de 3 mm en direction z.

**12.** Procédé de détermination de la forme de la surface limite extérieure et intérieure (G1, G2), y compris de la forme des surfaces terminales (82, 84), d'un dispositif de mesure selon une des revendications précédentes, **caractérisé par** les étapes suivantes :

- détermination de paramètres qui définissent la forme des surfaces limites (G1, G2), y compris la forme des surfaces terminales (82, 84) ;
- détermination d'une fonction de coût qui peut être calculée pour toute combinaison de paramètres et qui est construite de façon que des valeurs plus petites de la fonction de coût décrivent une amélioration de l'homogénéité de champ du champ magnétique dans le volume d'échantillon (88) en cas d'application du champ magnétique extérieur homogène $B_0$, la fonction de coût contenant entre autres un terme de la forme

$$-\sqrt{\int_V (F1 + F2)^2 \, dV}$$

dans lequel F1, F2 et V sont définis comme dans la revendication 1 ;
- application d'un algorithme numérique d'optimisation pour déterminer un jeu de paramètres qui déterminent un minimum de la fonction de coût.

Fig. 1

Fig. 2a     Fig. 2b     Fig. 2c

Fig. 3

Fig. 4a

Fig. 4b

Fig. 5a

Fig. 5b

Fig. 5c

Fig. 6a

Fig. 6b

Fig. 6c

Fig. 7

**Fig. 8**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 4549136 A
- US 5831434 A
- JP 6249934 B
- US 5302900 A

**In der Beschreibung aufgeführte Nicht-Patentliteratur**

- **J. C. MAXWELL.** A Treatise on Electricity and Magnetism. Dover Publications, 1954, vol. 2, 66-70
- **R. ULRICH et al.** Susceptibility corrections in solid state NMR experiments with oriented membrane samples. *Part II: Theory, J. Magn. Reson.,* 2003, vol. 164, 115-127
- **J. A. OSBORN.** Demagnetizing Factors of the General Ellipsoid. *Phys. Rev.,* 1945, vol. 67, 351-357
- **J. D. JACKSON.** Classical Electrodynamics. John Wiley, 1998